# EUROPEAN PATENT APPLICATION

(11) **EP 4 572 573 A1**
(43) Date of publication of application: **18.06.2025**
(21) Application number: 22957723.4
(22) Date of filing: 08.09.2022
(51) Int. Cl.: H10H 29/00

(54) **PIXEL APPARATUS, METHOD FOR MANUFACTURING PIXEL APPARATUS, AND RELATED DEVICE**

(71) Applicant: Huawei Technologies Co., Ltd., Shenzhen, Guangdong 518129 (CN)
(72) Inventor: ISHIZAKI, Koji, Shenzhen, Guangdong 518129 (CN); HAN, Gangfeng, Shenzhen, Guangdong 518129 (CN); CHAE, Geesung, Shenzhen, Guangdong 518129 (CN); KABE, Masaaki, Shenzhen, Guangdong 518129 (CN); HWANG, Inbom, Shenzhen, Guangdong 518129 (CN)
(74) Representative: Goddar, Heinz J.
(86) International application number: PCT/CN2022/117767
(87) International publication number: WO 2024/050751

(57) **Abstract**

Embodiments of this application provide a pixel apparatus. The pixel apparatus includes a light-emitting unit, an encapsulation layer, a transition layer, a light-absorbing layer, and a first filter unit. The transition layer is disposed between the encapsulation layer and the first filter unit. The transition layer is in contact with the encapsulation layer and the first filter unit. The light-absorbing layer is disposed in a direction in which the transition layer is away from the light-emitting unit. The light-absorbing layer is disposed around the first filter unit. The light-absorbing layer is in contact with the transition layer and the first filter unit. The transition layer is disposed between the encapsulation layer and the first filter unit, and the transition layer is in contact with the encapsulation layer and the first filter unit, so that a distance between the light-emitting unit and the first filter unit can be shortened, display luminance of the pixel apparatus can be improved, and luminance attenuation at a large angle of view can be reduced. In addition, there are no additional multi-layer insulation layers between the transition layer and the first filter unit, so that reliability of the pixel apparatus can be improved.

## Description

### TECHNICAL FIELD

Embodiments of this application relate to the field of electronic devices, and mainly to a pixel apparatus, a pixel apparatus preparation method, a display module, a display, and an electronic device.

### BACKGROUND

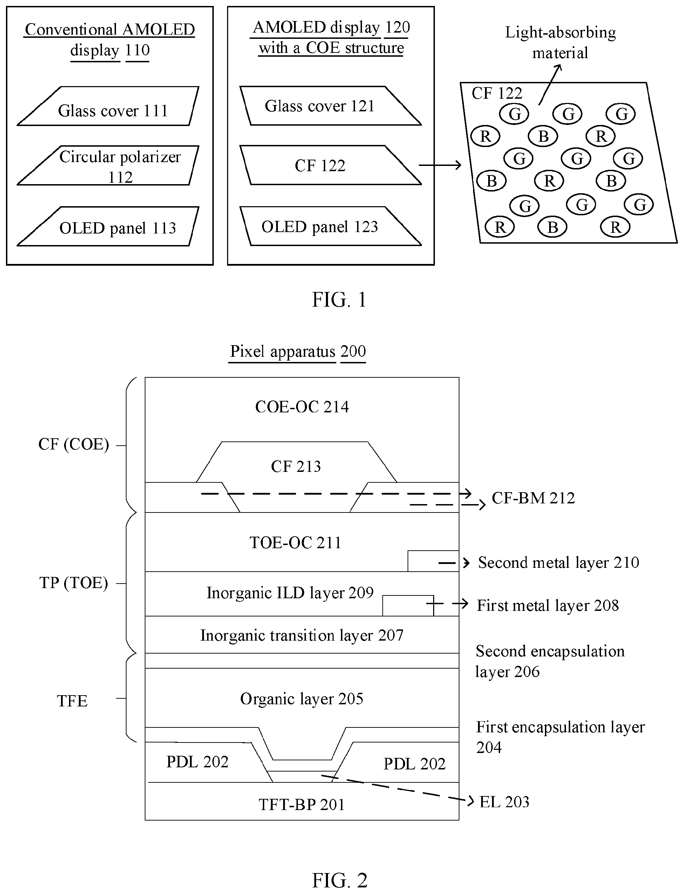

Currently, an active-matrix organic light-emitting diode (active-matrix organic light-emitting diode, AMOLED) panel is used in an increasing quantity of displays. However, after external light enters a conventional AMOLED display, it is difficult for the AMOLED display to absorb reflected light, and the light is likely to be reflected to an angle of view of a user. Therefore, a circular polarizer needs to be added to the AMOLED display to absorb reflected light. However, when light emitted by a light-emitting unit (for example, an electroluminescence (electroluminescence, EL) component) in the AMOLED display passes through the circular polarizer, light luminance may decrease by approximately 50%. Therefore, visual experience of the user is poor. Currently, an external reflection function of a polarizer may be internalized by using a color filter on encapsulation (color filter on encapsulation, COE) structure. To be specific, no circular polarizer needs to be added to an AMOLED display, and instead, reflected light is absorbed by the COE structure. FIG. 1 is a diagram of comparison between structures of a conventional AMOLED display and an AMOLED display with a COE structure. Currently, to reduce a thickness of a display, an external touch sensor (touch sensor) may be further integrated onto a thin film encapsulation (thin film encapsulation, TFE) of an AMOLED display by using a touch panel on encapsulation (touch panel on encapsulation, TOE) structure. If a plurality of layers included in the TOE structure are all inorganic material layers, peeling (peeling) or cracking (crack) is likely to occur when the TOE structure in the AMOLED display is bent or is subject to impact.

To alleviate the problem that the TOE structure in the AMOLED display is likely to peel off or crack, currently, some inorganic material layers in the TOE structure may be replaced with organic material layers, to improve reliability of the TOE structure. However, because the organic material layers are thicker than the inorganic material layers, a distance between a light-emitting unit (for example, an EL component) in the AMOLED display and a light exit surface (for example, a color filter (color filter, CF)) in the AMOLED display is long. Consequently, display luminance of the display and luminance attenuation at a large angle of view are affected.

Therefore, how to improve display luminance of a display and reduce luminance attenuation at a large angle of view while improving reliability of the display becomes a problem to be urgently resolved.

### SUMMARY

Embodiments of this application provide a pixel apparatus, a pixel apparatus preparation method, a display module, a display, and an electronic device, to shorten a distance between a light-emitting unit and a first filter unit in a pixel apparatus while improving reliability of the pixel apparatus, and further improve display luminance of the pixel apparatus and reduce luminance attenuation at a large angle of view.

According to a first aspect, a pixel apparatus is provided. The pixel apparatus includes a light-emitting unit, an encapsulation layer, a transition layer, a light-absorbing layer, and a first filter unit. The light-emitting unit is configured to emit light. The encapsulation layer is configured to protect the light-emitting unit. The transition layer is disposed between the encapsulation layer and the first filter unit. The transition layer is in contact with the encapsulation layer and the first filter unit. The light-absorbing layer is disposed in a direction in which the transition layer is away from the light-emitting unit. The light-absorbing layer is disposed around the first filter unit. The light-absorbing layer is in contact with the transition layer and the first filter unit.

In this embodiment of this application, the transition layer may be disposed between the encapsulation layer and the first filter unit, and the transition layer is in contact with the encapsulation layer and the first filter unit, so that a distance between the light-emitting unit and the first filter unit can be shortened, display luminance of the pixel apparatus can be improved, and luminance attenuation at a large angle of view can be reduced. In addition, there are no additional multi-layer insulation layers between the transition layer and the first filter unit, so that reliability of the pixel apparatus can be improved. In addition, in this embodiment of this application, a thickness of the pixel apparatus can be reduced, and a quantity of optical masks can be reduced in a preparation process for the pixel apparatus, to reduce preparation costs.

With reference to the first aspect, in some implementations of the first aspect, the transition layer does not include a metal component.

The transition layer in this embodiment of this application does not include a metal component. To be specific, the transition layer in this embodiment of this application is different from an inorganic interlayer dielectric (interlayer dielectric, ILD) layer, an organic ILD layer, and a touch panel on encapsulation-overcoating (touch panel on encapsulation-overcoating, TOE-OC) layer in the conventional technology. In addition, in this embodiment of this application, there are no additional multi-layer insulation layers between the first filter unit and the encapsulation layer. Therefore, a distance between the light-emitting unit and the first filter unit can be effectively shortened.

With reference to the first aspect, in some implementations of the first aspect, the transition layer is an inorganic material layer. In other words, the transition layer includes only an inorganic material.

With reference to the first aspect, in some implementations of the first aspect, when the transition layer is an inorganic material layer, a thickness of the transition layer ranges from 0.25 micrometers to 0.35 micrometers.

With reference to the first aspect, in some implementations of the first aspect, the transition layer is an organic material layer. In other words, the transition layer includes only an organic material.

With reference to the first aspect, in some implementations of the first aspect, when the transition layer is an organic material layer, a thickness of the transition layer ranges from 1 micrometer to 2 micrometers.

In this embodiment of this application, only the transition layer is disposed between the encapsulation layer and the first filter unit, and a thickness range of the transition layer is small. In the conventional technology, the inorganic ILD layer and the TOE-OC layer, or the organic ILD layer and the TOE-OC layer are further disposed between the transition layer and the first filter unit. A thickness of the inorganic ILD layer ranges from 0.25 micrometers to 0.35 micrometers. A thickness of the organic ILD layer ranges from 1 micrometer to 2 micrometers. A thickness of the TOE-OC approximately ranges from 2 micrometers to 3 micrometers. To be specific, a distance between the light-emitting unit and the first filter unit in this embodiment of this application is less than a distance in the conventional technology, so that display luminance of the pixel apparatus in this embodiment of this application is higher.

With reference to the first aspect, in some implementations of the first aspect, the pixel apparatus further includes a metal component, and a part or all of the metal component is disposed in the light-absorbing layer and/or the first filter unit.

In this embodiment of this application, the metal component may be disposed in the light-absorbing layer and/or the first filter unit, so that no additional insulation layer needs to be disposed between the light-absorbing layer and the light-emitting unit (in other words, between the first filter unit and the light-emitting unit) for placing the metal component at the insulation layer. Therefore, in this embodiment of this application, peeling, cracking, or other problems caused by an additional insulation layer can be avoided, to improve reliability of the pixel apparatus. In addition, in this embodiment of this application, the light-absorbing layer and/or the first filter unit may be reused, to shorten a distance between the light-emitting unit and the first filter unit in the pixel apparatus, and further improve display luminance of the pixel apparatus and reduce luminance attenuation at a large angle of view. In addition, in this embodiment of this application, a thickness of the pixel apparatus can be reduced, and a quantity of optical masks can be reduced in a preparation process for the pixel apparatus, to reduce preparation costs.

With reference to the first aspect, in some implementations of the first aspect, the metal component includes a first metal layer and a second metal layer. A part or all of the first metal layer is disposed in the light-absorbing layer and/or the first filter unit, and/or a part or all of the second metal layer is disposed in the light-absorbing layer and/or the first filter unit.

With reference to the first aspect, in some implementations of the first aspect, a height of a first surface of the first metal layer relative to the light-emitting unit is lower than a first height, the first height is a height of a first surface of the second metal layer relative to the light-emitting unit, the first surface of the first metal layer is a surface of the first metal layer that is close to the light-emitting unit, and the first surface of the second metal layer is a surface of the second metal layer that is close to the light-emitting unit.

In this embodiment of this application, the light-absorbing layer and/or the first filter unit may be reused, and the first metal layer and the second metal layer are disposed in the light-absorbing layer and/or the first filter unit to implement a touch function. In this way, no additional inorganic insulation layer needs to be disposed in the pixel apparatus for placing the first metal layer and the second metal layer, so that reliability of the pixel apparatus can be improved. In addition, in the manner in which the light-absorbing layer and/or the first filter unit are/is reused, a distance between the first filter unit and the light-emitting unit can be shortened, to improve display luminance of the pixel apparatus and reduce luminance attenuation at a large angle of view.

With reference to the first aspect, in some implementations of the first aspect, when a part or all of the metal component is disposed in a first part of the first filter unit, the pixel apparatus further includes a second filter unit. The second filter unit is disposed in a direction in which the first part of the first filter unit is away from the light-emitting unit. The second filter unit is in contact with the first part of the first filter unit. A color of the second filter unit is different from a color of the first filter unit. The first part of the first filter unit is an edge part of the first filter unit that is close to the light-absorbing layer.

In this embodiment of this application, when the metal component is disposed in the first filter unit, the second filter unit may be further disposed, to prevent external light from being reflected out of the pixel apparatus after passing through the metal component, so that visual experience of a user is improved.

With reference to the first aspect, in some implementations of the first aspect, the pixel apparatus further includes a lens, and the lens is disposed in a direction in which the first filter unit is away from the light-emitting unit.

In this embodiment of this application, the lens may be added to achieve light focusing effect, so that axial luminance of the pixel apparatus can be further improved without increasing power consumption of the pixel apparatus. In addition, because an optical distance between the light-emitting unit and the first filter unit in the pixel apparatus in this embodiment of this application is shortened, luminance attenuation of the pixel apparatus at a large angle of view can be reduced.

According to a second aspect, a pixel apparatus is provided. The pixel apparatus includes a light-emitting unit, a connection layer, a light-absorbing layer, a first filter unit, and a metal component. The light-emitting unit is configured to emit light. The connection layer is disposed between the light-emitting unit and the first filter unit. The connection layer is in contact with the light-emitting unit and the first filter unit. The light-absorbing layer is disposed in a direction in which the connection layer is away from the light-emitting unit. The light-absorbing layer is disposed around the first filter unit. The light-absorbing layer is in contact with the first filter unit and the connection layer. A part or all of the metal component is disposed in the light-absorbing layer and/or the first filter unit.

In this embodiment of this application, the metal component may be disposed in the light-absorbing layer and/or the first filter unit, so that no additional insulation layer needs to be disposed between the light-absorbing layer and the light-emitting unit (in other words, between the first filter unit and the light-emitting unit) for placing the metal component at the insulation layer. Therefore, in this embodiment of this application, peeling, cracking, or other problems caused by an additional insulation layer can be avoided, to improve reliability of the pixel apparatus. In addition, in this embodiment of this application, the light-absorbing layer and/or the first filter unit may be reused, to shorten a distance between the light-emitting unit and the first filter unit in the pixel apparatus, and further improve display luminance of the pixel apparatus and reduce luminance attenuation at a large angle of view. In addition, in this embodiment of this application, a thickness of the pixel apparatus can be reduced, and a quantity of optical masks can be reduced in a preparation process for the pixel apparatus, to reduce preparation costs.

With reference to the second aspect, in some implementations of the second aspect, the metal component includes a first metal layer and a second metal layer. A part or all of the first metal layer is disposed in the light-absorbing layer and/or the first filter unit, and/or a part or all of the second metal layer is disposed in the light-absorbing layer and/or the first filter unit.

With reference to the second aspect, in some implementations of the second aspect, a height of a first surface of the first metal layer relative to the light-emitting unit is lower than a first height, the first height is a height of a first surface of the second metal layer relative to the light-emitting unit, the first surface of the first metal layer is a surface of the first metal layer that is close to the light-emitting unit, and the first surface of the second metal layer is a surface of the second metal layer that is close to the light-emitting unit.

In this embodiment of this application, the light-absorbing layer and/or the first filter unit may be reused, and the first metal layer and the second metal layer are disposed in the light-absorbing layer and/or the first filter unit to implement a touch function. In this way, no additional inorganic insulation layer needs to be disposed in the pixel apparatus for placing the first metal layer and the second metal layer, so that reliability of the pixel apparatus can be improved. In addition, in the manner in which the light-absorbing layer and/or the first filter unit are/is reused, a distance between the first filter unit and the light-emitting unit can be shortened, to improve display luminance of the pixel apparatus and reduce luminance attenuation at a large angle of view.

With reference to the second aspect, in some implementations of the second aspect, when a part or all of the metal component is disposed in a first part of the first filter unit, the pixel apparatus further includes a second filter unit. The second filter unit is disposed in a direction in which the first part of the first filter unit is away from the light-emitting unit. The second filter unit is in contact with the first part of the first filter unit. A color of the second filter unit is different from a color of the first filter unit. The first part of the first filter unit is an edge part of the first filter unit that is close to the light-absorbing layer.

In this embodiment of this application, when the metal component is disposed in the first filter unit, the second filter unit may be further disposed, to prevent external light from being reflected out of the pixel apparatus after passing through the metal component, so that visual experience of a user is improved.

With reference to the second aspect, in some implementations of the second aspect, the connection layer includes an encapsulation layer and a transition layer. The encapsulation layer is configured to protect the light-emitting unit. The transition layer is disposed between the encapsulation layer and the first filter unit. The transition layer is in contact with the encapsulation layer, the first filter unit, and the light-absorbing layer.

In this embodiment of this application, the transition layer may be disposed between the encapsulation layer and the first filter unit, and the transition layer is in contact with the encapsulation layer and the first filter unit, so that a distance between the light-emitting unit and the first filter unit can be shortened, display luminance of the pixel apparatus can be improved, and luminance attenuation at a large angle of view can be reduced. In addition, there are no additional multi-layer insulation layers between the transition layer and the first filter unit, so that reliability of the pixel apparatus can be improved. In addition, in this embodiment of this application, a thickness of the pixel apparatus can be reduced, and a quantity of optical masks can be reduced in a preparation process for the pixel apparatus, to reduce preparation costs.

With reference to the second aspect, in some implementations of the second aspect, the transition layer does not include a metal component.

The transition layer in this embodiment of this application does not include a metal component. To be specific, the transition layer in this embodiment of this application is different from an inorganic ILD layer, an organic ILD layer, and a TOE-OC in the conventional technology. In addition, in this embodiment of this application, there are no additional multi-layer insulation layers between the first filter unit and the encapsulation layer. Therefore, a distance between the light-emitting unit and the first filter unit can be effectively shortened.

With reference to the second aspect, in some implementations of the second aspect, the transition layer is an inorganic material layer. In other words, the transition layer includes only an inorganic material.

With reference to the second aspect, in some implementations of the second aspect, when the transition layer is an inorganic material layer, a thickness of the transition layer ranges from 0.25 micrometers to 0.35 micrometers.

With reference to the second aspect, in some implementations of the second aspect, the transition layer is an organic material layer. In other words, the transition layer includes only an organic material.

With reference to the second aspect, in some implementations of the second aspect, when the transition layer is an organic material layer, a thickness of the transition layer ranges from 1 micrometer to 2 micrometers.

In this embodiment of this application, only the transition layer is disposed between the encapsulation layer and the first filter unit, and a thickness range of the transition layer is small. In the conventional technology, the inorganic ILD layer and the TOE-OC layer, or the organic ILD layer and the TOE-OC layer are further disposed between the transition layer and the first filter unit. A thickness of the inorganic ILD layer ranges from 0.25 micrometers to 0.35 micrometers. A thickness of the organic ILD layer ranges from 1 micrometer to 2 micrometers. A thickness of the TOE-OC approximately ranges from 2 micrometers to 3 micrometers. To be specific, a distance between the light-emitting unit and the first filter unit in this embodiment of this application is less than a distance in the conventional technology, so that display luminance of the pixel apparatus in this embodiment of this application is higher.

With reference to the second aspect, in some implementations of the second aspect, the pixel apparatus further includes a lens, and the lens is disposed in a direction in which the first filter unit is away from the light-emitting unit.

In this embodiment of this application, the lens may be added to achieve light focusing effect, so that axial luminance of the pixel apparatus can be further improved without increasing power consumption of the pixel apparatus. In addition, because an optical distance between the light-emitting unit and the first filter unit in the pixel apparatus in this embodiment of this application is shortened, luminance attenuation of the pixel apparatus at a large angle of view can be reduced.

According to a third aspect, a pixel apparatus preparation method is provided. The method includes: forming a light-emitting unit of a pixel apparatus on a substrate, where the light-emitting unit is configured to emit light, forming an encapsulation layer in a direction in which the light-emitting unit is away from the substrate, where the encapsulation layer is configured to protect the light-emitting unit; forming a transition layer in a direction in which the encapsulation layer is away from the light-emitting unit; and forming a light-absorbing layer and a first filter unit in a direction in which the transition layer is away from the encapsulation layer, where the transition layer is in contact with the encapsulation layer and the first filter unit, the light-absorbing layer is disposed around the first filter unit, and the light-absorbing layer is in contact with the transition layer and the first filter unit.

In this embodiment of this application, the transition layer may be disposed between the encapsulation layer and the first filter unit, and the transition layer is in contact with the encapsulation layer and the first filter unit, so that a distance between the light-emitting unit and the first filter unit can be shortened, display luminance of the pixel apparatus can be improved, and luminance attenuation at a large angle of view can be reduced. In addition, there are no additional multi-layer insulation layers between the transition layer and the first filter unit, so that reliability of the pixel apparatus can be improved. In addition, in this embodiment of this application, a thickness of the pixel apparatus can be reduced, and a quantity of optical masks can be reduced in a preparation process for the pixel apparatus, to reduce preparation costs.

With reference to the third aspect, in some implementations of the third aspect, the transition layer does not include a metal component.

The transition layer in this embodiment of this application does not include a metal component. To be specific, the transition layer in this embodiment of this application is different from an inorganic ILD layer, an organic ILD layer, and a TOE-OC in the conventional technology. In addition, in this embodiment of this application, there are no additional multi-layer insulation layers between the first filter unit and the encapsulation layer. Therefore, a distance between the light-emitting unit and the first filter unit can be effectively shortened.

With reference to the third aspect, in some implementations of the third aspect, the transition layer is an inorganic material layer. In other words, the transition layer includes only an inorganic material.

With reference to the third aspect, in some implementations of the third aspect, when the transition layer is an inorganic material layer, a thickness of the transition layer ranges from 0.25 micrometers to 0.35 micrometers.

With reference to the third aspect, in some implementations of the third aspect, the transition layer is an organic material layer. In other words, the transition layer includes only an organic material.

With reference to the third aspect, in some implementations of the third aspect, when the transition layer is an organic material layer, a thickness of the transition layer ranges from 1 micrometer to 2 micrometers.

In this embodiment of this application, only the transition layer is disposed between the encapsulation layer and the first filter unit, and a thickness range of the transition layer is small. In the conventional technology, the inorganic ILD layer and the TOE-OC layer, or the organic ILD layer and the TOE-OC layer are further disposed between the transition layer and the first filter unit. A thickness of the inorganic ILD layer ranges from 0.25 micrometers to 0.35 micrometers. A thickness of the organic ILD layer ranges from 1 micrometer to 2 micrometers. A thickness of the TOE-OC approximately ranges from 2 micrometers to 3 micrometers. To be specific, a distance between the light-emitting unit and the first filter unit in this embodiment of this application is less than a distance in the conventional technology, so that display luminance of the pixel apparatus in this embodiment of this application is higher.

With reference to the third aspect, in some implementations of the third aspect, a metal component is formed in the direction in which the transition layer is away from the encapsulation layer, and a part or all of the metal component is disposed in the light-absorbing layer and/or the first filter unit.

In this embodiment of this application, the metal component may be disposed in the light-absorbing layer and/or the first filter unit, so that no additional insulation layer needs to be disposed between the light-absorbing layer and the light-emitting unit (in other words, between the first filter unit and the light-emitting unit) for placing the metal component at the insulation layer. Therefore, in this embodiment of this application, peeling, cracking, or other problems caused by an additional insulation layer can be avoided, to improve reliability of the pixel apparatus. In addition, in this embodiment of this application, the light-absorbing layer and/or the first filter unit may be reused, to shorten a distance between the light-emitting unit and the first filter unit in the pixel apparatus, and further improve display luminance of the pixel apparatus and reduce luminance attenuation at a large angle of view. In addition, in this embodiment of this application, a thickness of the pixel apparatus can be reduced, and a quantity of optical masks can be reduced in a preparation process for the pixel apparatus, to reduce preparation costs.

With reference to the third aspect, in some implementations of the third aspect, a first metal layer and a second metal layer are formed in the direction in which the transition layer is away from the encapsulation layer. A part or all of the first metal layer is disposed in the light-absorbing layer and/or the first filter unit, and/or a part or all of the second metal layer is disposed in the light-absorbing layer and/or the first filter unit.

With reference to the third aspect, in some implementations of the third aspect, a height of a first surface of the first metal layer relative to the light-emitting unit is lower than a first height. The first height is a height of a first surface of the second metal layer relative to the light-emitting unit. The first surface of the first metal layer is a surface of the first metal layer that is close to the light-emitting unit. The first surface of the second metal layer is a surface of the second metal layer that is close to the light-emitting unit.

In this embodiment of this application, the light-absorbing layer and/or the first filter unit may be reused, and the first metal layer and the second metal layer are disposed in the light-absorbing layer and/or the first filter unit to implement a touch function. In this way, no additional inorganic insulation layer needs to be disposed in the pixel apparatus for placing the first metal layer and the second metal layer, so that reliability of the pixel apparatus can be improved. In addition, in the manner in which the light-absorbing layer and/or the first filter unit are/is reused, a distance between the first filter unit and the light-emitting unit can be shortened, to improve display luminance of the pixel apparatus and reduce luminance attenuation at a large angle of view.

With reference to the third aspect, in some implementations of the third aspect, a second filter unit is formed in a direction in which a first part of the first filter unit is away from the light-emitting unit. The second filter unit is in contact with the first part of the first filter unit. A color of the second filter unit is different from a color of the first filter unit. A part or all of the metal component is disposed in the first part of the first filter unit. The first part of the first filter unit is an edge part of the first filter unit that is close to the light-absorbing layer.

In this embodiment of this application, when the metal component is disposed in the first filter unit, the second filter unit may be further disposed, to prevent external light from being reflected out of the pixel apparatus after passing through the metal component, so that visual experience of a user is improved.

With reference to the third aspect, in some implementations of the third aspect, a lens is formed in a direction in which the first filter unit is away from the light-emitting unit.

In this embodiment of this application, the lens may be added to achieve light focusing effect, so that axial luminance of the pixel apparatus can be further improved without increasing power consumption of the pixel apparatus. In addition, because an optical distance between the light-emitting unit and the first filter unit in the pixel apparatus in this embodiment of this application is shortened, luminance attenuation of the pixel apparatus at a large angle of view can be reduced.

According to a fourth aspect, a pixel apparatus preparation method is provided. The method includes: forming a light-emitting unit of a pixel apparatus on a substrate, where the light-emitting unit is configured to emit light, forming a connection layer in a direction in which the light-emitting unit is away from the substrate; and forming a light-absorbing layer, a first filter unit, and a metal component in a direction in which the connection layer is away from the light-emitting unit, where the connection layer is in contact with the light-emitting unit and the first filter unit, the light-absorbing layer is disposed around the first filter unit, the light-absorbing layer is in contact with the first filter unit and the connection layer, and a part or all of the metal component is disposed in the light-absorbing layer and/or the first filter unit.

In this embodiment of this application, the metal component may be disposed in the light-absorbing layer and/or the first filter unit, so that no additional insulation layer needs to be disposed between the light-absorbing layer and the light-emitting unit (in other words, between the first filter unit and the light-emitting unit) for placing the metal component at the insulation layer. Therefore, in this embodiment of this application, peeling, cracking, or other problems caused by an additional insulation layer can be avoided, to improve reliability of the pixel apparatus. In addition, in this embodiment of this application, the light-absorbing layer and/or the first filter unit may be reused, to shorten a distance between the light-emitting unit and the first filter unit in the pixel apparatus, and further improve display luminance of the pixel apparatus and reduce luminance attenuation at a large angle of view. In addition, in this embodiment of this application, a thickness of the pixel apparatus can be reduced, and a quantity of optical masks can be reduced in a preparation process for the pixel apparatus, to reduce preparation costs.

With reference to the fourth aspect, in some implementations of the fourth aspect, a first metal layer and a second metal layer are formed in the direction in which the connection layer is away from the light-emitting unit. A part or all of the first metal layer is disposed in the light-absorbing layer and/or the first filter unit, and/or a part or all of the second metal layer is disposed in the light-absorbing layer and/or the first filter unit.

With reference to the fourth aspect, in some implementations of the fourth aspect, a height of a first surface of the first metal layer relative to the light-emitting unit is lower than a first height. The first height is a height of a first surface of the second metal layer relative to the light-emitting unit. The first surface of the first metal layer is a surface of the first metal layer that is close to the light-emitting unit. The first surface of the second metal layer is a surface of the second metal layer that is close to the light-emitting unit.

In this embodiment of this application, the light-absorbing layer and/or the first filter unit may be reused, and the first metal layer and the second metal layer are disposed in the light-absorbing layer and/or the first filter unit to implement a touch function. In this way, no additional inorganic insulation layer needs to be disposed in the pixel apparatus for placing the first metal layer and the second metal layer, so that reliability of the pixel apparatus can be improved. In addition, in the manner in which the light-absorbing layer and/or the first filter unit are/is reused, a distance between the first filter unit and the light-emitting unit can be shortened, to improve display luminance of the pixel apparatus and reduce luminance attenuation at a large angle of view.

With reference to the fourth aspect, in some implementations of the fourth aspect, a second filter unit is formed in a direction in which a first part of the first filter unit is away from the light-emitting unit. The second filter unit is in contact with the first part of the first filter unit. A color of the second filter unit is different from a color of the first filter unit. A part or all of the metal component is disposed in the first part of the first filter unit. The first part of the first filter unit is an edge part of the first filter unit that is close to the light-absorbing layer.

In this embodiment of this application, when the metal component is disposed in the first filter unit, the second filter unit may be further disposed, to prevent external light from being reflected out of the pixel apparatus after passing through the metal component, so that visual experience of a user is improved.

With reference to the fourth aspect, in some implementations of the fourth aspect, an encapsulation layer is formed in the direction in which the light-emitting unit is away from the substrate, where the encapsulation layer is configured to protect the light-emitting unit; and a transition layer is formed in a direction in which the encapsulation layer is away from the substrate, where the transition layer is disposed between the encapsulation layer and the first filter unit, and the transition layer is in contact with the encapsulation layer, the first filter unit, and the light-absorbing layer.

In this embodiment of this application, the transition layer may be disposed between the encapsulation layer and the first filter unit, and the transition layer is in contact with the encapsulation layer and the first filter unit, so that a distance between the light-emitting unit and the first filter unit can be shortened, display luminance of the pixel apparatus can be improved, and luminance attenuation at a large angle of view can be reduced. In addition, there are no additional multi-layer insulation layers between the transition layer and the first filter unit, so that reliability of the pixel apparatus can be improved. In addition, in this embodiment of this application, a thickness of the pixel apparatus can be reduced, and a quantity of optical masks can be reduced in a preparation process for the pixel apparatus, to reduce preparation costs.

With reference to the fourth aspect, in some implementations of the fourth aspect, the transition layer does not include a metal component.

The transition layer in this embodiment of this application does not include a metal component. To be specific, the transition layer in this embodiment of this application is different from an inorganic ILD layer, an organic ILD layer, and a TOE-OC in the conventional technology. In addition, in this embodiment of this application, there are no additional multi-layer insulation layers between the first filter unit and the encapsulation layer. Therefore, a distance between the light-emitting unit and the first filter unit can be effectively shortened.

With reference to the fourth aspect, in some implementations of the fourth aspect, the transition layer is an inorganic material layer. In other words, the transition layer includes only an inorganic material.

With reference to the fourth aspect, in some implementations of the fourth aspect, when the transition layer is an inorganic material layer, a thickness of the transition layer ranges from 0.25 micrometers to 0.35 micrometers.

With reference to the fourth aspect, in some implementations of the fourth aspect, the transition layer is an organic material layer. In other words, the transition layer includes only an organic material.

With reference to the fourth aspect, in some implementations of the fourth aspect, when the transition layer is an organic material layer, a thickness of the transition layer ranges from 1 micrometer to 2 micrometers.

In this embodiment of this application, only the transition layer is disposed between the encapsulation layer and the first filter unit, and a thickness range of the transition layer is small. In the conventional technology, the inorganic ILD layer and the TOE-OC layer, or the organic ILD layer and the TOE-OC layer are further disposed between the transition layer and the first filter unit. A thickness of the inorganic ILD layer ranges from 0.25 micrometers to 0.35 micrometers. A thickness of the organic ILD layer ranges from 1 micrometer to 2 micrometers. A thickness of the TOE-OC approximately ranges from 2 micrometers to 3 micrometers. To be specific, a distance between the light-emitting unit and the first filter unit in this embodiment of this application is less than a distance in the conventional technology, so that display luminance of the pixel apparatus in this embodiment of this application is higher.

With reference to the fourth aspect, in some implementations of the fourth aspect, a lens is formed in a direction in which the first filter unit is away from the light-emitting unit.

In this embodiment of this application, the lens may be added to achieve light focusing effect, so that axial luminance of the pixel apparatus can be further improved without increasing power consumption of the pixel apparatus. In addition, because an optical distance between the light-emitting unit and the first filter unit in the pixel apparatus in this embodiment of this application is shortened, luminance attenuation of the pixel apparatus at a large angle of view can be reduced.

According to a fifth aspect, a pixel module is provided. The pixel module includes a plurality of pixel apparatuses according to any one of the first aspect or the possible implementations of the first aspect, or a plurality of pixel apparatuses according to any one of the second aspect or the possible implementations of the second aspect.

According to a sixth aspect, a display module is provided. The display module includes a plurality of pixel modules according to the fifth aspect.

According to a seventh aspect, a display is provided. The display includes the display module according to the sixth aspect.

According to an eighth aspect, an electronic device is provided. The electronic device includes the display according to the seventh aspect.

### BRIEF DESCRIPTION OF DRAWINGS

FIG. 1 is a diagram of comparison between structures of a conventional AMOLED and an AMOLED display with a COE structure;
FIG. 2 is a schematic sectional view of a pixel apparatus with an inorganic TOE and a COE structure;
FIG. 3 is a schematic sectional view of a pixel apparatus with an organic TOE and a COE structure;
FIG. 4 is a schematic sectional view of a pixel apparatus with an organic TOE, a COE, and a lens;
FIG. 5 is a diagram of a structure of a pixel apparatus according to an embodiment of this application;
FIG. 6 is a diagram of a structure of a pixel apparatus according to another embodiment of this application;
FIG. 7 is a diagram of a structure of a pixel apparatus according to another embodiment of this application;
FIG. 8 is a diagram of a structure of a pixel apparatus according to another embodiment of this application;
FIG. 9 is a diagram of a structure of a pixel apparatus according to another embodiment of this application;
FIG. 10 is a diagram of a structure of a pixel apparatus according to another embodiment of this application;
FIG. 11 is a diagram of a structure of a pixel apparatus according to another embodiment of this application;
FIG. 12 is a diagram of a structure of a pixel apparatus according to another embodiment of this application;
FIG. 13 is a diagram of a structure of a pixel apparatus according to another embodiment of this application;
FIG. 14 is a diagram of optical simulation of display luminance of different pixel apparatuses according to an embodiment of this application;
FIG. 15 is a schematic flowchart of a pixel apparatus preparation method according to an embodiment of this application;
FIG. 16 is a schematic flowchart of a pixel apparatus preparation method according to another embodiment of this application; and
FIG. 17 is a block diagram of a structure of a display module according to an embodiment of this application.

### DESCRIPTION OF EMBODIMENTS

The following describes technical solutions in embodiments of this application with reference to accompanying drawings.

The technical solutions in embodiments of this application may be used for various electronic devices with a pixel apparatus, for example, a watch, a mobile phone, a tablet computer, a smart screen, a notebook computer, or a desktop computer. This is not limited in embodiments of this application.

FIG. 1 is a diagram of comparison between structures of a conventional AMOLED and an AMOLED display with a COE structure. FIG. 1 includes a conventional AMOLED display 110 and an AMOLED display 120 with a COE structure.

The conventional AMOLED display 110 includes a glass cover 111, a circular polarizer 112, and an organic light-emitting diode (organic light-emitting diode, OLED) OLED panel 113. The glass cover 111 may be configured to protect other structures or components in the display 110, for example, the circular polarizer 112 and the OLED panel 113. The circular polarizer 112 is configured to filter or adjust light that enters the conventional AMOLED display 110 from the outside, and absorb light reflected from the OLED panel 113 to an angle of view of a user, to improve visual experience of the user when the user views a screen in a scenario with strong light. However, when light emitted by the OLED panel 113 passes through the circular polarizer 112, a part of light is also absorbed by the circular polarizer 112. Consequently, compared with luminance of the light emitted by the OLED panel 113, luminance of light that enters the angle of view of the user decreases by approximately 50%. The OLED panel 113 includes at least one organic light-emitting diode, and the at least one organic light-emitting diode may emit light with a same wavelength or different wavelengths.

The AMOLED display 120 with the COE structure includes a glass cover 121, a CF 122, and an OLED panel 123. The glass cover 121 is similar to the glass cover 111, and the OLED panel 123 is similar to the OLED panel 113.

The CF 122 may include a plurality of thin films in different colors, for example, red (red, R), green (green, G), and blue (blue, B). A thin film in each color may filter out light in a color other than the color, to present a color image. A light-absorbing material is applied between thin films. When light is emitted from the outside, the light-absorbing material may absorb a part of light emitted from the outside and a part of light reflected by the OLED panel 123. To be specific, the light-absorbing material may be used to reduce light reflection. Transmittance of the CF 122 can be improved based on the light-absorbing material and the thin films in different colors. To be specific, at same power consumption, the CF 122 can enable the AMOLED display 120 with the COE structure to have higher display luminance than the conventional AMOLED display 110, to be specific, light that enters the angle of view of the user is brighter. In other words, at same display luminance, the CF 122 can enable the AMOLED display 120 with the COE structure to have lower power consumption than the conventional AMOLED display 110.

FIG. 2 is a schematic sectional view of a pixel apparatus with an inorganic TOE and a COE structure. The pixel apparatus 200 in FIG. 2 includes a thin film transistor-back panel (thin film transistor-back panel, TFT-BP) TFT-BP 201, a pixel define layer (pixel define layer, PDL) PDL 202, an EL 203, a first encapsulation layer 204, an organic layer 205, a second encapsulation layer 206, an inorganic transition layer 207, a first metal layer 208, an inorganic ILD layer 209, a second metal layer 210, a TOE-OC 211, a color filter-black matrix (color filter-black matrix) CF-BM layer 212, a CF 213, and a color filter on encapsulation-overcoating (color filter on encapsulation-overcoating) COE-OC layer 214.

It should be understood that the CF 213 in FIG. 2 may be a thin film in any color in the CF 122 in FIG. 1. To be specific, one thin film in the CF 122 is used as an example for description in FIG. 2.

In some embodiments, the pixel apparatus 200 includes any one or more of the following: at least one EL 203, at least one first metal layer 208, at least one second metal layer 210, and at least one CF 213.

In some embodiments, the pixel apparatus 200 includes a light-emitting structure, a thin film encapsulation (thin film encapsulation, TFE) TFE structure, a touch panel (touch panel) TP structure, and a CF structure. The TP structure may also be referred to as a TOE structure, and the CF structure may also be referred to as a COE structure. The light-emitting structure may include the TFT-BP 201, the PDL 202, and the EL 203. The TFE structure includes the first encapsulation layer 204, the organic layer 205, and the second encapsulation layer 206. The TP structure includes the inorganic transition layer 207, the first metal layer 208, the inorganic ILD layer 209, the second metal layer 210, and the TOE-OC 211. The CF structure includes the CF-BM 212, the CF 213, and the COE-OC 214.

The TFT-BP 201 is a thin film transistor-back panel layer of the pixel apparatus 200, and includes a back panel of the pixel apparatus 200, a polyimide (polyimide, PI) layer, at least one thin film transistor, and other structures. The thin film transistor may be configured to drive the EL 203, and adjust a voltage input to the EL 203, to change transmission intensity of light emitted by the EL 203. The TFT-BP 201 is disposed at a bottom layer of a section of the pixel apparatus 200. To be specific, the TFT-BP 201 is located at a lowest height layer of the pixel apparatus 200. During actual preparation, a height layer at which the TFT-BP 201 is located is lower than a height layer at which a structure other than the TFT-BP 201 shown in FIG. 2 is located.

The PDL 202 is a pixel define layer of the pixel apparatus 200, and is configured to prevent current leakage and crosstalk between a plurality of ELs 203. The PDL 202 includes an organic or inorganic insulation material. The PDL 202 is disposed between the TFT-BP 201 and the first encapsulation layer 204, may be in contact with the TFT-BP 201 and the first encapsulation layer 204, and is non-conductive. During actual preparation, a height layer at which the PDL 202 is located is higher than the height layer at which the TFT-BP 201 is located. A height of the height layer at which the PDL 202 is located may be understood as a height of the PDL 202 relative to the TFT-BP 201.

The EL 203 is a light-emitting component of the pixel apparatus 200, and may be configured to emit light. The EL 203 is disposed between the TFT-BP 201 and the first encapsulation layer 204, and may be in contact with the TFT-BP 201 and the first encapsulation layer 204. To be specific, a first surface of the EL 203 and a first surface of the PDL 202 are at a same height relative to the TFT-BP 201, and the EL 203 is in contact with the PDL 202. The first surface of the EL 203 is a surface of the EL 203 that is close to the TFT-BP 201. The first surface of the PDL 202 is a surface of the PDL 202 that is close to the TFT-BP 201. During actual preparation, a height layer at which the EL 203 is located is higher than the height layer at which the TFT-BP 201 is located. A height of the height layer at which the EL 203 is located may be understood as a height of the EL 203 relative to the TFT-BP 201.

The first encapsulation layer 204 is a water blocking layer of the pixel apparatus 200, and is configured to isolate vapor or oxygen that penetrates into the EL 203, to protect the EL 203. The first encapsulation layer 204 includes an inorganic insulation material. The first encapsulation layer 204 is disposed between the PDL 202 and the organic layer 205, and may be in contact with the PDL 202 and the organic layer 205. In other words, the first encapsulation layer 204 is disposed between the EL 203 and the organic layer 205, and may be in contact with the EL 203 and the organic layer 205. During actual preparation, a height layer at which the first encapsulation layer 204 is located is higher than the height layers at which the PDL 202 and the EL 203 are located. A height of the height layer at which the first encapsulation layer 204 is located may be understood as a height of the first encapsulation layer 204 relative to the TFT-BP 201.

The organic layer 205 is a planarization layer of the pixel apparatus 200, and is configured to perform planarization (planarization), to facilitate formation of the second encapsulation layer 206 with good quality, and further prevent penetration of vapor and oxygen. The organic layer 205 includes an organic insulation material. The organic layer 205 is disposed between the first encapsulation layer 204 and the second encapsulation layer 206, may be in contact with the first encapsulation layer 204 and the second encapsulation layer 206, and is non-conductive. During actual preparation, a height layer at which the organic layer 205 is located is higher than the height layer at which the first encapsulation layer 204 is located. A height of the height layer at which the organic layer 205 is located may be understood as a height of the organic layer 205 relative to the TFT-BP 201.

The second encapsulation layer 206 is a water blocking layer of the pixel apparatus 200, and is configured to further isolate vapor or oxygen that penetrates into the EL 203, to provide effective protection for the EL 203. The second encapsulation layer 206 includes an inorganic insulation material. The second encapsulation layer 206 is similar to the first encapsulation layer 204. The second encapsulation layer 206 is disposed between the organic layer 205 and the inorganic transition layer 207, may be in contact with the organic layer 205 and the inorganic transition layer 207, and is non-conductive. During actual preparation, a height layer at which the second encapsulation layer 206 is located is higher than the height layer at which the organic layer 205 is located. A height of the height layer at which the second encapsulation layer 206 is located may be understood as a height of the second encapsulation layer 206 relative to the TFT-BP 201.

The inorganic transition layer 207 is a planarization layer of the pixel apparatus 200, and is configured to perform planarization, to facilitate formation of the first metal layer 208 and the inorganic ILD layer 209 with good quality, and protect the second encapsulation layer 206. The inorganic transition layer 207 includes an inorganic insulation material. The inorganic transition layer 207 is disposed between the second encapsulation layer 206 and the inorganic ILD layer 209, may be in contact with the second encapsulation layer 206 and the inorganic ILD layer 209, and is non-conductive. In other words, the inorganic transition layer 207 is disposed between the second encapsulation layer 206 and the first metal layer 208, may be in contact with the second encapsulation layer 206 and the first metal layer 208, and is non-conductive. During actual preparation, a height layer at which the inorganic transition layer 207 is located is higher than the height layer at which the second encapsulation layer 206 is located. A height of the height layer at which the inorganic transition layer 207 is located may be understood as a height of the inorganic transition layer 207 relative to the TFT-BP 201.

The first metal layer 208 is a metal electrode of a touch sensor in the pixel apparatus 200. The first metal layer 208 may be, for example, a metal wire. The first metal layer 208 is disposed between the inorganic transition layer 207 and the TOE-OC 211. In other words, the first metal layer 208 is disposed in the inorganic ILD layer 209. A first surface of the first metal layer 208 and a first surface of the inorganic ILD layer 209 are at a same height relative to the TFT-BP 201. The first surface of the first metal layer 208 is a surface of the first metal layer 208 that is close to the inorganic transition layer 207. The first surface of the inorganic ILD layer 209 is a surface of the inorganic ILD layer 209 that is close to the inorganic transition layer 207. During actual preparation, a height layer at which the first metal layer 208 is located is higher than the height layer at which the inorganic transition layer 207 is located. A height of the height layer at which the first metal layer 208 is located may be understood as a height of the first metal layer 208 relative to the TFT-BP 201.

The inorganic ILD layer 209 is an interlayer dielectric layer of the pixel apparatus 200, and is configured to isolate the first metal layer 208 from the second metal layer 210, to prevent current leakage or interference between the first metal layer 208 and the second metal layer 210. The inorganic ILD layer 209 includes an inorganic insulation material and the first metal layer 208. The insulation material in the inorganic ILD layer 209 may be in contact with another surface of the first metal layer 208. The another surface of the first metal layer 208 is a surface of the first metal layer 208 other than the first surface. The inorganic ILD layer 209 is disposed between the inorganic transition layer 207 and the TOE-OC 211, may be in contact with the inorganic transition layer 207 and the TOE-OC 211, and is non-conductive. During actual preparation, a height layer at which the inorganic ILD layer 209 is located is higher than the height layer at which the inorganic transition layer 207 is located. A height of the height layer at which the inorganic ILD layer 209 is located may be understood as a height of the inorganic ILD layer 209 relative to the TFT-BP 201.

The second metal layer 210 is a metal electrode of the touch sensor in the pixel apparatus 200. The second metal layer 210 may be, for example, a metal wire. The second metal layer 210 is disposed between the inorganic ILD layer 209 and the CF-BM 212, or the second metal layer 210 is disposed between the inorganic ILD layer 209 and the CF 213. In other words, the second metal layer 210 is disposed in the TOE-OC 211. A first surface of the second metal layer 210 and a first surface of the TOC-OC 211 are at a same height relative to the TFT-BP 201. The first surface of the second metal layer 210 is a surface of the second metal layer 210 that is close to the inorganic ILD layer 209. The first surface of the TOC-OC 211 is a surface of the TOC-OC 211 that is close to the inorganic ILD layer 209. During actual preparation, a height layer at which the second metal layer 210 is located is higher than the height layer at which the inorganic ILD layer 209 is located. A height of the height layer at which the second metal layer 210 is located may be understood as a height of the second metal layer 210 relative to the TFT-BP 201.

The TOE-OC 211 is an overcoating layer of the pixel apparatus 200, and is configured to protect the second metal layer 210, and can further facilitate formation of the CF-BM 212 and the CF 213 with good quality. The TOE-OC 211 includes an organic insulation material and the second metal layer 210. The insulation material in the TOE-OC 211 may be in contact with another surface of the second metal layer 210. The another surface of the second metal layer 210 is a surface of the second metal layer 210 other than the first surface. The TOE-OC 211 is disposed between the inorganic ILD layer 209 and the CF-BM 212, may be in contact with the inorganic ILD layer 209 and the CF-BM 212, and is non-conductive. In other words, the TOE-OC 211 is disposed between the inorganic ILD layer 209 and the CF 213, may be in contact with the inorganic ILD layer 209 and the CF 213, and is non-conductive. During actual preparation, a height layer at which the TOE-OC 211 is located is higher than the height layer at which the inorganic ILD layer 209 is located. A height of the height layer at which the TOE-OC 211 is located may be understood as a height of the TOE-OC 211 relative to the TFT-BP 201.

The CF-BM 212 is a black matrix layer of the pixel apparatus 200, and is configured to isolate a plurality of CFs 213, to prevent color mixing between the plurality of CFs 213. The CF-BM 212 can further prevent light transmission, to prevent light reflection and improving visual experience of a user. The CF-BM 212 includes an insulation light-absorbing material. The CF-BM 212 is disposed between the TOE-OC 211 and the COE-OC 214, may be in contact with the TOE-OC 211 and the COE-OC 214, and is non-conductive. During actual preparation, a height layer at which the CF-BM 212 is located is higher than the height layer at which the TOE-OC 211 is located. A height of the height layer at which the CF-BM 212 is located may be understood as a height of the CF-BM 212 relative to the TFT-BP 201.

The CF 213 is a color filter of the pixel apparatus 200, and is configured to enable light emitted by the EL 203 to exit the pixel apparatus 200, and can enable the light to present different colors, for example, red (R), green (G), or blue (B). The CF 213 includes an insulation material. The CF 213 is disposed between the TOE-OC 211 and the COE-OC 214, may be in contact with the TOE-OC 211 and the COE-OC 214, and is non-conductive. A first surface of the CF 213 and a first surface of the CF-BM 212 are at a same height relative to the TFT-BP 201, and the CF 213 is in contact with the CF-BM 212. The first surface of the CF 213 is a surface of the CF 213 that is close to the TOE-OC 211. The first surface of the CF-BM 212 is a surface of the CF-BM 212 that is close to the TOE-OC 211. During actual preparation, a height layer at which the CF 213 is located is higher than the height layer at which the TOE-OC 211 is located. A height of the height layer at which the CF 213 is located may be understood as a height of the CF 213 relative to the TFT-BP 201.

The COE-OC 214 is an overcoating layer of the pixel apparatus 200, and is configured to protect the CF-BM 212 and the CF 213. The COE-OC 214 includes an insulation material, and the insulation material in the COE-OC 214 may be in contact with a second surface of the CF-BM 212 and a second surface of the CF 213. The second surface of the CF-BM 212 is a surface of the CF-BM 212 that is away from the TFT-BP 201. The second surface of the CF 213 is a surface of the CF 213 that is away from the TFT-BP 201. The COE-OC 214 is disposed in a direction in which the CF-BM 212 and the CF 213 are away from the TFT-BP 201, is in contact with the CF-BM 212 and the CF 213, and is non-conductive. During actual preparation, a height layer at which the COE-OC 214 is located is higher than the height layers at which the CF-BM 212 and the CF 213 are located. A height of the height layer at which the COE-OC 214 is located may be understood as a height of the COE-OC 214 relative to the TFT-BP 201.

In some embodiments, the pixel apparatus 200 may further include a glass cover. The glass cover is similar to the glass cover 111 or the glass cover 121 in FIG. 1. Details are not described herein again.

In some embodiments, the organic insulation material may include rubber, resin, plastic, an acrylic material, and the like.

In some embodiments, the inorganic insulation material may include a material prepared by using silicon dioxide and a silicate compound of silicon dioxide as main components, or may include a material prepared by using an oxide, a nitride, a carbide, a boride, a sulfide, a silicide, and various non-metallic compounds through a special advanced process.

In some embodiments, a thickness of the TFT-BP 201 approximately ranges from 20 micrometers to 30 micrometers (*µm*). A thickness of the PDL 202 approximately ranges from 1.5 micrometers to 2.5 micrometers. A thickness range of the EL 203 is approximately 10 nanometers (nm). Thicknesses of the first encapsulation layer 204 and the second encapsulation layer 206 approximately range from 0.8 micrometer to 1.2 micrometers. A thickness of the organic layer 205 approximately ranges from 8 micrometers to 12 micrometers. Thicknesses of the inorganic transition layer 207 and the inorganic ILD layer 209 approximately range from 0.25 micrometers to 0.35 micrometers. Thicknesses of the first metal layer 208 and the second metal layer 210 approximately range from 0.25 micrometers to 0.35 micrometers. Thicknesses of the TOE-OC 211 and the COE-OC 214 approximately range from 2 micrometers to 3 micrometers. Thickness units of the CF-BM 212 and the CF 213 are approximately 1.5 micrometers to 2 micrometers. That is, a thickness of the pixel apparatus 200 approximately ranges from 37.1 micrometers to 55.6 micrometers.

Because both the inorganic transition layer 207 and the inorganic ILD layer 209 of the pixel apparatus 200 include an inorganic insulation material, the inorganic transition layer 207 and the inorganic ILD layer 209 are prone to peeling and/or cracking when being bent and/or being subject to impact. In addition, because the pixel apparatus 200 includes a hierarchical structure made of a plurality of different materials, a large quantity of light masks (mask) are needed during actual production and preparation, and production costs are high.

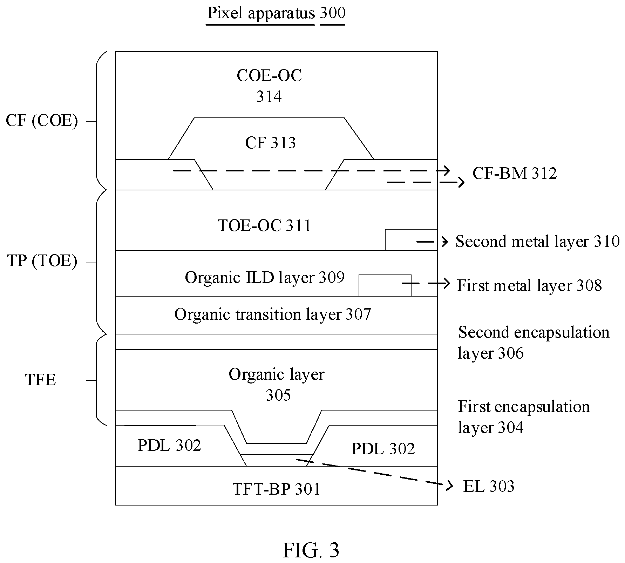

FIG. 3 is a schematic sectional view of a pixel apparatus with an organic TOE and a COE structure. The pixel apparatus 300 in FIG. 3 includes a TFT-BP 301, a PDL 302, an EL 303, a first encapsulation layer 304, an organic layer 305, a second encapsulation layer 306, an organic transition layer 307, a first metal layer 308, an organic ILD layer 309, a second metal layer 310, a TOE-OC 311, a CF-BM 312, a CF 313, and a COE-OC 314.

It should be understood that the CF 313 in FIG. 3 may be a thin film in any color in the CF 122 in FIG. 1. To be specific, one thin film in the CF 122 is used as an example for description in FIG. 3.

It can be learned from FIG. 3 that, in the pixel apparatus 300 in FIG. 3, the inorganic transition layer 207 of the pixel apparatus 200 in FIG. 2 is replaced with the organic transition layer 307, and the inorganic ILD layer 209 of the pixel apparatus 200 is replaced with the organic ILD layer 309. Except for the organic transition layer 307 and the organic ILD layer 309, a structure of the pixel apparatus 300 is similar to the structure of the pixel apparatus 200. Details are not described herein again.

The organic transition layer 307 includes an organic insulation material. A purpose and a location of the organic transition layer 307 in the pixel apparatus 300 are similar to the purpose and the location of the inorganic transition layer 207 in the pixel apparatus 200. Details are not described herein again.

The organic ILD layer 309 includes an organic insulation material. A purpose and a location of the organic ILD layer 309 in the pixel apparatus 300 are similar to the purpose and the location of the inorganic ILD layer 209 in the pixel apparatus 200. Details are not described herein again.

In some embodiments, thicknesses of the organic transition layer 307 and the organic ILD layer 309 approximately range from 1 micrometer to 2 micrometers. That is, a thickness of the pixel apparatus 300 approximately ranges from 38.6 micrometers to 58.9 micrometers.

Because both the organic transition layer 307 and the organic ILD layer 309 of the pixel apparatus 300 include an organic insulation material, the organic transition layer 307 and the organic ILD layer 309 are thicker than the inorganic transition layer 207 and the inorganic ILD layer 209. To be specific, a distance between the EL 303 and the COE-OC 314 in the pixel apparatus 300 is longer. Consequently, display luminance of the pixel apparatus 300 may be reduced, and luminance attenuation of the pixel apparatus 300 at a large angle of view is high. The display luminance of the pixel apparatus 300 is luminance of light that is emitted by the EL 303 and that has passed through the COE-OC 314.

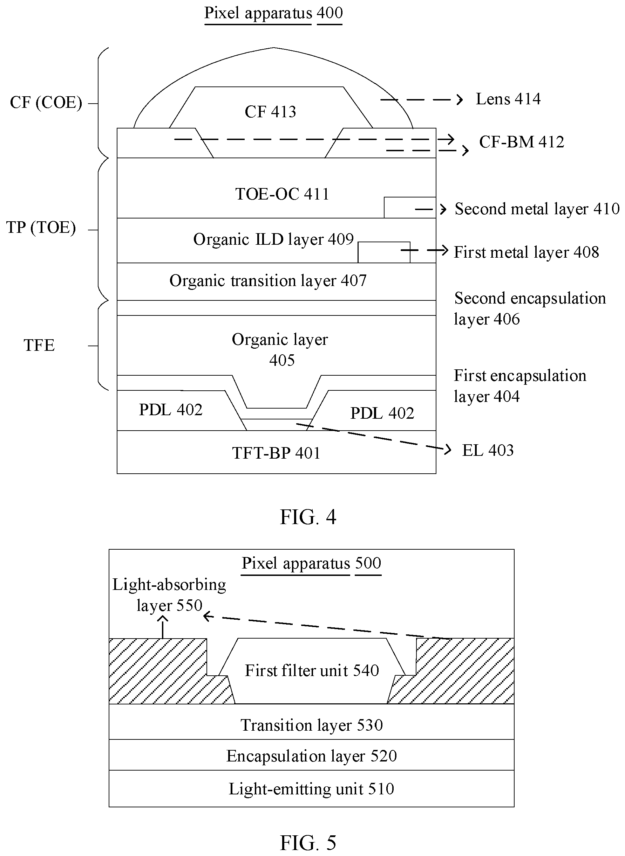

FIG. 4 is a schematic sectional view of a pixel apparatus with an organic TOE, a COE, and a lens. The pixel apparatus 400 in FIG. 4 includes a TFT-BP 401, a PDL 402, an EL 403, a first encapsulation layer 404, an organic layer 405, a second encapsulation layer 406, an organic transition layer 407, a first metal layer 408, an organic ILD layer 409, a second metal layer 410, a TOE-OC 411, a CF-BM 412, a CF 413, and a lens 414. It can be learned from FIG. 4 that a structure of the pixel apparatus 400 except for the lens 414 is similar to the structure of the pixel apparatus 300 included in FIG. 3 except for the COE-OC 314. Details are not described herein again.

It should be understood that the CF 413 in FIG. 4 may be a thin film in any color in the CF 122 in FIG. 1. To be specific, one thin film in the CF 122 is used as an example for description in FIG. 4.

The lens 414 may be configured to focus light, to improve display luminance of the pixel apparatus 400. The lens 414 includes an organic insulation material. The lens 414 is disposed in a direction in which the CF 413 is away from the TFT-BP 401, and the insulation material in the lens 414 may be in contact with a second surface of the CF 413. In other words, the insulation material in the lens 414 may be in contact with a part of a second surface of the CF-BM 412 and the second surface of the CF 413. The second surface of the CF-BM 412 is a surface of the CF-BM 412 that is away from the TFT-BP 401. The second surface of the CF 413 is a surface of the CF 413 that is away from the TFT-BP 401. During actual preparation, a height layer at which the lens 414 is located is higher than height layers at which the CF-BM 412 and the CF 413 are located. A height of the height layer at which the lens 414 is located may be understood as a height of the lens 414 relative to the TFT-BP 401.

In some embodiments, a thickness of the lens 414 approximately ranges from 5 micrometers to 10 micrometers. That is, a thickness of the pixel apparatus 300 approximately ranges from 41.6 micrometers to 43.9 micrometers.

Although the lens 414 in FIG. 4 performs a light focusing function, the lens 414 is likely to cause an increase in luminance attenuation of the pixel apparatus 400 at a large angle of view. The large angle of view of the pixel apparatus 400 is an angle greater than 30 degrees among viewing angles of the pixel apparatus 400. The viewing angle of the pixel apparatus 400 includes a horizontal viewing angle and/or a vertical viewing angle. The horizontal viewing angle is an angle at which an image displayed on the pixel apparatus 400 can be observed from a left or right side perpendicular to a vertical normal line of the pixel apparatus 400 with the vertical normal line as a reference. For example, in the schematic sectional view of the pixel apparatus 400 shown in FIG. 4, the vertical normal line of the pixel apparatus 400 is in a direction that runs through the pixel apparatus 400 and that is perpendicular to the CF 413. The vertical viewing angle is an angle at which the image displayed on the pixel apparatus 400 can be observed from an upper or lower side perpendicular to a horizontal normal line of the pixel apparatus 400 with the horizontal normal line as a reference. For example, in the schematic sectional view of the pixel apparatus 400 shown in FIG. 4, the horizontal normal line of the pixel apparatus 400 is in a sectional direction of the pixel apparatus 400. The vertical viewing angle of the pixel apparatus 400 may be an angle of a first included angle, and the first included angle is an included angle between the sectional direction and a maximum direction, in which the image displayed on the pixel apparatus 400 can be viewed, outside a screen at a height higher than the lens 414. It should be understood that, an included angle between the sectional direction and a maximum direction, in which the image displayed on the pixel apparatus 400 can be viewed, inside the screen at a height higher than the lens 414 is the same as the angle of the first included angle.

The luminance attenuation of the pixel apparatus 400 at the large angle of view is a range, at the large angle of view, of a decrease in display luminance of the pixel apparatus 400 that is observed from an angle of view of a user when the angle of view of the user moves from a horizontal normal direction or a vertical normal direction of the pixel apparatus 400 to a direction in which the pixel apparatus 400 is located.

FIG. 5 is a diagram of a structure of a pixel apparatus according to an embodiment of this application. The pixel apparatus 500 in FIG. 5 includes a light-emitting unit 510, an encapsulation layer 520, a transition layer 530, a first filter unit 540, and a light-absorbing layer 550.

It should be understood that the first filter unit 540 in FIG. 5 may be a thin film in any color in the CF 122 in FIG. 1. To be specific, one first filter unit is used as an example for description in FIG. 5.

The light-emitting unit 510 is configured to emit light. The light-emitting unit 510 is disposed at a bottom layer of the pixel apparatus 500.

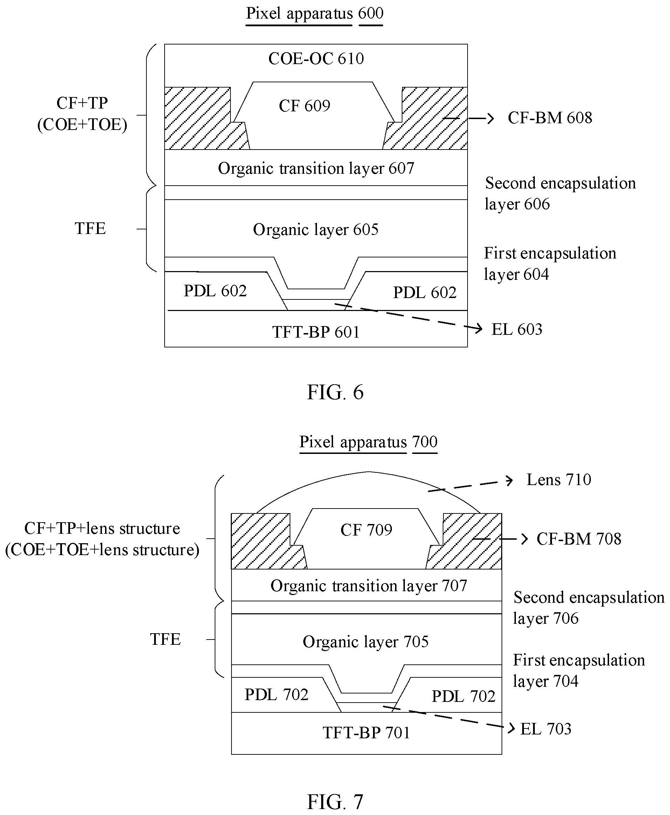

In some embodiments, the light-emitting unit 510 may include an EL component. For example, the light-emitting unit 510 may be similar to the EL 203 of the pixel apparatus 200 in FIG. 2, the EL 303 of the pixel apparatus 300 in FIG. 3, the EL 403 of the pixel apparatus 400 in FIG. 4, an EL 603 of a pixel apparatus 600 in FIG. 6, or an EL 703 of a pixel apparatus 700 in FIG. 7. Details are not described herein again.

In some embodiments, the light-emitting unit 510 may include an EL component and a PDL structure. For example, the light-emitting unit 510 may be similar to the PDL 202 and the EL 203 of the pixel apparatus 200 in FIG. 2. Alternatively, the light-emitting unit 510 may be similar to the PDL 302 and the EL 303 of the pixel apparatus 300 in FIG. 3. Alternatively, the light-emitting unit 510 may be similar to the PDL 402 and the EL 403 of the pixel apparatus 400 in FIG. 4. Alternatively, the light-emitting unit 510 may be similar to a PDL 602 and the EL 603 of the pixel apparatus 600 in FIG. 6. Alternatively, the light-emitting unit 510 may be similar to a PDL 702 and the EL 703 of the pixel apparatus 700 in FIG. 7.

In some embodiments, the light-emitting unit 510 may include an EL component, a PDL structure, and a TFT-BP structure. For example, the light-emitting unit 510 may be similar to the TFT-BP 201, the PDL 202, and the EL 203 of the pixel apparatus 200 in FIG. 2. Alternatively, the light-emitting unit 510 may be similar to the TFT-BP 301, the PDL 302, and the EL 303 of the pixel apparatus 300 in FIG. 3. Alternatively, the light-emitting unit 510 may be similar to the TFT-BP 401, the PDL 402, and the EL 403 of the pixel apparatus 400 in FIG. 4. Alternatively, the light-emitting unit 510 may be similar to a TFT-BP 601, the PDL 602, and the EL 603 of the pixel apparatus 600 in FIG. 6. Alternatively, the light-emitting unit 510 may be similar to a TFT-BP 701, the PDL 702, and the EL 703 of the pixel apparatus 700 in FIG. 7.

The encapsulation layer 520 is configured to protect the light-emitting unit 510. The encapsulation layer 520 is disposed between the light-emitting unit 510 and the transition layer 530, and may be in contact with the light-emitting unit 510 and the transition layer 530.

In some embodiments, the encapsulation layer 520 includes a first surface and a second surface. The first surface of the encapsulation layer 520 is in contact with the light-emitting unit 510, and the second surface of the encapsulation layer 520 is in contact with the transition layer 530.

In some embodiments, the encapsulation layer 520 may include an organic insulation material and/or an inorganic insulation material, and the encapsulation layer 520 is non-conductive. For example, the encapsulation layer 520 may be made of resin and/or a silicide. This is not limited in this embodiment of this application.

In some embodiments, the encapsulation layer 520 may include the first encapsulation layer 204, the organic layer 205, and the second encapsulation layer 206 of the pixel apparatus 200 in FIG. 2. Alternatively, the encapsulation layer 520 may include the first encapsulation layer 304, the organic layer 305, and the second encapsulation layer 306 of the pixel apparatus 300 in FIG. 3. Alternatively, the encapsulation layer 520 may include the first encapsulation layer 404, the organic layer 405, and the second encapsulation layer 406 of the pixel apparatus 400 in FIG. 4. Alternatively, the encapsulation layer 520 may include a first encapsulation layer 604, an organic layer 605, and a second encapsulation layer 606 of the pixel apparatus 600 in FIG. 6. Alternatively, the encapsulation layer 520 may include a first encapsulation layer 704, an organic layer 705, and a second encapsulation layer 706 of the pixel apparatus 700 in FIG. 7. This is not limited in this embodiment of this application.

The transition layer 530 is disposed between the encapsulation layer 520 and the first filter unit 540, and the transition layer 530 is in contact with the encapsulation layer 520 and the first filter unit 540.

In some embodiments, the transition layer 530 includes a first surface and a second surface. The first surface of the transition layer 530 is in contact with the encapsulation layer 520, and the second surface of the transition layer 530 is in contact with the first filter unit 540.

In some embodiments, the transition layer 530 does not include a metal component.

In some embodiments, the transition layer 530 may include an organic or inorganic insulation material, and the transition layer 530 is non-conductive. For example, the transition layer 530 may be made of resin or a silicide. This is not limited in this embodiment of this application.

When the transition layer 530 is an inorganic material layer, in other words, the transition layer 530 includes only an inorganic material, a thickness of the transition layer 530 approximately ranges from 0.25 micrometers to 0.35 micrometers.

When the transition layer 530 is an organic material layer, in other words, the transition layer 530 includes only an organic material, a thickness of the transition layer 530 approximately ranges from 1 micrometer to 2 micrometers.

In some embodiments, the transition layer 530 may be similar to the inorganic transition layer 207 of the pixel apparatus 200 in FIG. 2. Alternatively, the transition layer 530 may be similar to the organic transition layer 307 of the pixel apparatus 300 in FIG. 3. Alternatively, the transition layer 530 may be similar to the organic transition layer 407 of the pixel apparatus 400 in FIG. 4. Alternatively, the transition layer 530 may be similar to an organic transition layer 607 of the pixel apparatus 600 in FIG. 6. Alternatively, the transition layer 530 may be similar to an organic transition layer 707 of the pixel apparatus 700 in FIG. 7. This is not limited in this embodiment of this application.

The first filter unit 540 is configured to filter light emitted by the light-emitting unit 510, and the first filter unit 540 is in contact with the transition layer 530 and the light-absorbing layer 550.

In some embodiments, the first filter unit 540 includes a first surface, a second surface, and a third surface. The first surface of the first filter unit 540 is a surface of the first filter unit 540 that is close to the light-emitting unit 510, and the first surface of the first filter unit 540 is in contact with the transition layer 530. The second surface of the first filter unit 540 is a surface of the first filter unit 540 that is away from the light-emitting unit 510. The third surface of the first filter unit 540 is a surface of the first filter unit 540 that is close to the light-absorbing layer 550, and the third surface of the first filter unit 540 is in contact with the light-absorbing layer 550.

In some embodiments, the first surface of the first filter unit 540 and a first surface of the light-absorbing layer 550 may be at a same height or different heights relative to the light-emitting unit 510. This is not limited in this embodiment of this application.

In some embodiments, the first filter unit 540 may include an organic or inorganic insulation material, and is non-conductive. For example, the first filter unit 540 may be made of resin or a silicide. This is not limited in this embodiment of this application.

In some embodiments, the first filter unit 540 may be in any one of three primary colors. The three primary colors may be red, green, and blue, or may be red, yellow, and blue. This is not limited in this embodiment of this application.

In some embodiments, the pixel apparatus 500 may include at least one light-emitting unit 510 and at least one first filter unit 540. The at least one light-emitting unit 510 is in a one-to-one correspondence with the at least one first filter unit 540. Each first filter unit 540 may be in any one of the three primary colors, so that white light emitted by a corresponding light-emitting unit 510 can be filtered to change to the color of the first filter unit 540, and a color image can be further obtained through mixing through a plurality of first filter units 540 in different colors.

In some embodiments, the first filter unit 540 may be similar to the CF 213 of the pixel apparatus 200 in FIG. 2. Alternatively, the first filter unit 540 may be similar to the CF 313 of the pixel apparatus 300 in FIG. 3. Alternatively, the first filter unit 540 may be similar to the CF 413 of the pixel apparatus 400 in FIG. 4. Alternatively, the first filter unit 540 may be similar to a CF 609 of the pixel apparatus 600 in FIG. 6. Alternatively, the first filter unit 540 may be similar to a CF 709 of the pixel apparatus 700 in FIG. 7.

The light-absorbing layer 550 is disposed in a direction in which the transition layer 530 is away from the light-emitting unit 510, and the light-absorbing layer 550 is disposed around the first filter unit 540. The light-absorbing layer 550 is in contact with the transition layer 530 and the first filter unit 540.

In some embodiments, the light-absorbing layer 550 may include a first surface, a second surface, and a third surface. The first surface of the light-absorbing layer 550 is a surface of the light-absorbing layer 550 that is close to the light-emitting unit 510, and the first surface of the light-absorbing layer 550 is in contact with the transition layer 530. The second surface of the light-absorbing layer 550 is a surface of the light-absorbing layer 550 that is away from the light-emitting unit 510. The third surface of the light-absorbing layer 550 is a surface of the light-absorbing layer 550 that is close to the first filter unit 540, and the third surface of the light-absorbing layer 550 is in contact with the first filter unit 540.

In some embodiments, a part or all of the third surface of the light-absorbing layer 550 may be in contact with the first filter unit 540, or the third surface of the light-absorbing layer 550 may not be in contact with the first filter unit 540. This is not limited in this embodiment of this application.

In some embodiments, the first surface of the light-absorbing layer 550 and the first surface of the first filter unit 540 are at a same height relative to the light-emitting unit 510. In other words, the first surface of the light-absorbing layer 550 and the first surface of the first filter unit 540 are located at a same height.

In some embodiments, a height of the first surface of the light-absorbing layer 550 relative to the light-emitting unit 510 is higher than a height of the first filter unit 540 relative to the light-emitting unit 510. Alternatively, a height of the first surface of the light-absorbing layer 550 relative to the light-emitting unit 510 is lower than a height of the first filter unit 540 relative to the light-emitting unit 510. This is not limited in this embodiment of this application.

In some embodiments, the light-absorbing layer 550 may include an organic or inorganic light-absorbing material, and the light-absorbing layer 550 is non-conductive. For example, the light-absorbing layer 550 may be made of chromium, nickel, resin, or a silicide. This is not limited in this embodiment of this application.

When the light-absorbing layer 550 includes a metal component, the light-absorbing material in the light-absorbing layer 550 may be a composite including photoresist, resin, light-shielding dye, and other components. The light-shielding dye is used to make the light-absorbing material present a color, to absorb reflected light. The light-shielding dye may be, for example, black light-shielding dye or dark light-shielding dye. The photoresist is used to protect the metal component, and can isolate vapor or oxygen that penetrates into the metal component during preparation of the pixel apparatus 500, to prevent the metal component from being corroded by the vapor or the oxygen. The resin may be used as an adhesive.

In some embodiments, the light-absorbing layer 550 may be in a black color. Alternatively, the light-absorbing layer 550 may be in a gray color with a high grayscale, another dark color, or the like. This is not limited in this embodiment of this application.

In some embodiments, the pixel apparatus 500 may include at least one first filter unit 540. The light-absorbing layer 550 may be configured to isolate a plurality of first filter units 540, to prevent color-cross between the plurality of first filter units 540. To be specific, the light-absorbing layer 550 may be disposed between the plurality of first filter units 540. The light-absorbing layer 550 may be further configured to prevent light transmission and light reflection.

In some embodiments, the light-absorbing layer 550 may be similar to the CF-BM 212 of the pixel apparatus 200 in FIG. 2. Alternatively, the light-absorbing layer 550 may be similar to the CF-BM 312 of the pixel apparatus 300 in FIG. 3. Alternatively, the light-absorbing layer 550 may be similar to the CF-BM 412 of the pixel apparatus 400 in FIG. 4. Alternatively, the light-absorbing layer 550 may be similar to a CF-BM 608 of the pixel apparatus 600 in FIG. 6. Alternatively, the light-absorbing layer 550 may be similar to a CF-BM 708 of the pixel apparatus 700 in FIG. 7.

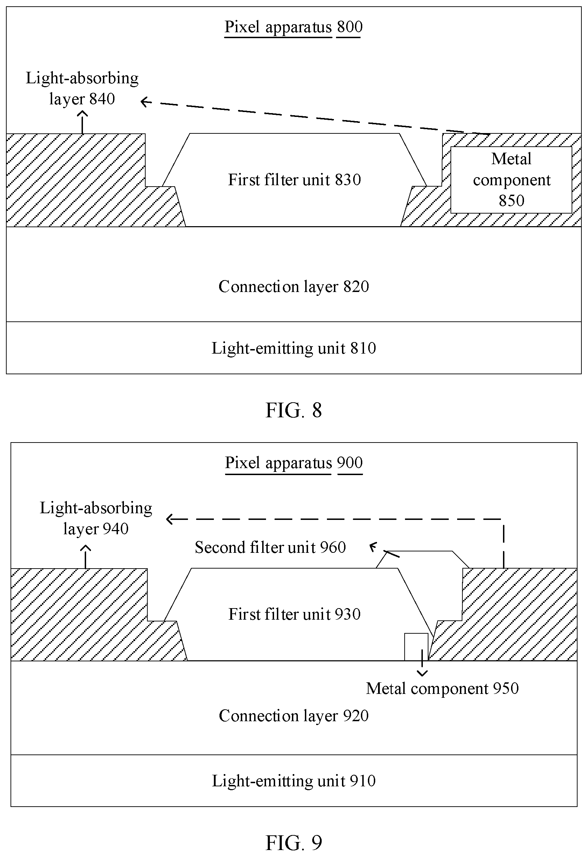

Optionally, the pixel apparatus 500 may further include a metal component, and all or a part of the metal component is disposed in the first filter unit 540 and/or the light-absorbing layer 550, as shown in any pixel apparatus in FIG. 8 to FIG. 13.

In some embodiments, the metal component may include a first metal layer and a second metal layer. A part or all of the first metal layer is disposed in the first filter unit 540 and/or the light-absorbing layer 550, and/or a part or all of the second metal layer is disposed in the first filter unit 540 and/or the light-absorbing layer 550.

In some embodiments, a height of a first surface of the first metal layer relative to the light-emitting unit 510 is lower than a first height, and the first height is a height of a first surface of the second metal layer relative to the light-emitting unit 510. The first surface of the first metal layer is a surface of the first metal layer that is close to the light-emitting unit 510. The first surface of the second metal layer is a surface of the second metal layer that is close to the light-emitting unit 510.

When a part or all of the metal component is disposed in a first part of the first filter unit 540, the pixel apparatus 500 may further include a second filter unit. The second filter unit is disposed in a direction in which the first part of the first filter unit 540 is away from the light-emitting unit 510, and the second filter unit is in contact with the first part of the first filter unit 540. A color of the second filter unit is different from a color of the first filter unit 540. The first part of the first filter unit 540 is an edge part of the first filter unit 540 that is close to the light-absorbing layer 550.

In some embodiments, the metal component may be similar to the first metal layer 208 and/or the second metal layer 210 of the pixel apparatus 200 in FIG. 2. Alternatively, the metal component may be similar to the first metal layer 308 and/or the second metal layer 310 of the pixel apparatus 300 in FIG. 3. Alternatively, the metal component may be similar to the first metal layer 408 and/or the second metal layer 410 of the pixel apparatus 400 in FIG. 4. Alternatively, the metal component may be similar to a metal component 850 of the pixel apparatus 800 in FIG. 8. Alternatively, the metal component may be similar to a metal component 950 of the pixel apparatus 900 in FIG. 9.

Optionally, the pixel apparatus 500 may further include a lens. The lens is disposed in a direction in which the first filter unit 540 is away from the light-emitting unit 510.

In some embodiments, a height of a first surface of the lens relative to the light-emitting unit 510 is higher than a second height, and the second height is a height of the first surface of the first filter unit 540 relative to the light-emitting unit 510. The first surface of the lens is a surface of the lens that is close to the light-emitting unit 510. In addition, the height of the first surface of the lens relative to the light-emitting unit 510 is higher than the height of the first surface of the light-absorbing layer 550 relative to the light-emitting unit 510.

In some embodiments, the first surface of the lens is in contact with a part or all of the second surface of the first filter unit 540. Alternatively, the first surface of the lens is in contact with a part of the second surface of the light-absorbing layer 550 and a part or all of the second surface of the first filter unit 540.

In some embodiments, an insulation material may be applied between the first surface of the lens and the second surface of the first filter unit 540, and the insulation material may be configured to protect the first filter unit 540. To be specific, the first surface of the lens is partially in contact with or completely not in contact with the second surface of the first filter unit 540. Similarly, the first surface of the lens is partially in contact with or completely not in contact with a part of the second surface of the light-absorbing layer 550 and the second surface of the first filter unit 540.

In some embodiments, the lens may include an organic or inorganic insulation material, and the lens is non-conductive. For example, the lens may be made of resin or a silicide. This is not limited in this embodiment of this application.

In some embodiments, the pixel apparatus 500 may include at least one first filter unit 540 and at least one lens. The at least one first filter unit 540 is in a one-to-one correspondence with the at least one lens, and each lens may be configured to assist a corresponding first filter unit 540 in light focusing.

In some embodiments, the lens may be similar to the lens 414 of the pixel apparatus 400 in FIG. 4, or may be similar to a lens 710 in FIG. 7. This is not limited in this embodiment of this application.

In some embodiments, the pixel apparatus 500 may include any one or more of the following: at least one light-emitting unit 510, at least one first filter unit 540, at least one metal component, and at least one lens.

In the pixel apparatus 500, the transition layer may be disposed between the encapsulation layer and the first filter unit, and the transition layer is in contact with the first filter unit, so that a distance between the light-emitting unit and the first filter unit can be shortened, display luminance of the pixel apparatus can be improved, and luminance attenuation at a large angle of view can be reduced. In addition, there are no additional multi-layer insulation layers between the transition layer and the first filter unit, so that reliability of the pixel apparatus can be improved. In addition, in this embodiment of this application, a thickness of the pixel apparatus 500 can be reduced, and a quantity of optical masks can be reduced in a preparation process for the pixel apparatus 500, to reduce preparation costs.

FIG. 6 is a diagram of a structure of a pixel apparatus according to an embodiment of this application. The pixel apparatus 600 in FIG. 6 includes a TFT-BP 601, a PDL 602, an EL 603, a first encapsulation layer 604, an organic layer 605, a second encapsulation layer 606, an organic transition layer 607, a CF-BM 608, a CF 609, and a COE-OC 610.

It should be understood that the CF 609 in FIG. 6 may be a thin film in any color in the CF 122 in FIG. 1. To be specific, one thin film in the CF 122 is used as an example for description in FIG. 6.

In some embodiments, the pixel apparatus 600 includes at least one EL 603 and/or at least one CF 609.

In some embodiments, the pixel apparatus 600 includes a light-emitting structure, a TFE structure, and a CF+TP structure. The CF+TP structure may also be referred to as a COE+TOE structure. The light-emitting structure includes the TFT-BP 601, the PDL 602, and the EL 603. The TFE structure includes the first encapsulation layer 604, the organic layer 605, and the second encapsulation layer 606. The CF+TP structure includes the organic transition layer 607, the CF-BM 608, the CF 609, and the COE-OC 610.

In some embodiments, the TFT-BP 601, the PDL 602, the EL 603, the first encapsulation layer 604, the organic layer 605, and the second encapsulation layer 606 are similar to structures of the pixel apparatus 200 in FIG. 2, the pixel apparatus 300 in FIG. 3, or the pixel apparatus 400 in FIG. 4. Details are not described herein again.

In some embodiments, the EL 603 may be the light-emitting unit 510 of the pixel apparatus 500 in FIG. 5. Alternatively, the PDL 602 and the EL 603 may be the light-emitting unit 510 in FIG. 5. Alternatively, the TFT-BP 601, the PDL 602, and the EL 603 may be the light-emitting unit 510 in FIG. 5. This is not limited in this embodiment of this application.

In some embodiments, the first encapsulation layer 604, the organic layer 605, and the second encapsulation layer 606 may be the encapsulation layer 520 of the pixel apparatus 500 in FIG. 5.

In some embodiments, the organic transition layer 607 is similar to the organic transition layer 307 in the pixel apparatus 300, the organic transition layer 407 in the pixel apparatus 400, or the transition layer 530 in the pixel apparatus 500. Details are not described herein again.

In some embodiments, the CF-BM 608 is a black matrix layer in the pixel apparatus 600, and is disposed between the organic transition layer 607 and the COE-OC 610. The CF-BM 608 is disposed around the CF 609, and the CF-BM 608 may be in contact with the organic transition layer 607 and the COE-OC 610, and may be further in contact with the CF 609. The CF-BM 608 is non-conductive. The CF-BM 608 includes a light-absorbing material. During actual preparation, a height layer at which the CF-BM 608 is located is higher than a height layer at which the organic transition layer 607 is located. A height of the height layer at which the CF-BM 608 is located may be understood as a height of the CF-BM 608 relative to the TFT-BP 601.

In some embodiments, the CF-BM 608 may be similar to the CF-BM 212 in the pixel apparatus 200, the CF-BM 312 in the pixel apparatus 300, the CF-BM 412 in the pixel apparatus 400, the light-absorbing layer 550 in the pixel apparatus 500, or the CF-BM 708 in the pixel apparatus 700. Details are not described herein again.

In some embodiments, the CF 609 is a color filter of the pixel apparatus 600. The CF 609 is disposed between the organic transition layer 607 and the COE-OC 610. A first surface of the CF 609 and a first surface of the CF-BM 608 are at a same height relative to the TFT-BP 601. The CF 609 may be in contact with an insulation material in the organic transition layer 607 and an insulation material in the COE-OC 610, and may be further in contact with the light-absorbing material in the CF-BM 608. The CF 609 includes an insulation material, and is non-conductive. During actual preparation, a height layer at which the CF 609 is located is higher than the height layer at which the organic transition layer 607 is located. A height of the height layer at which the CF 609 is located may be understood as a height of the CF 609 relative to the TFT-BP 601.

In some embodiments, the CF 609 may be similar to the CF 213 in the pixel apparatus 200, the CF 313 in the pixel apparatus 300, the CF 413 in the pixel apparatus 400, the first filter unit 540 in the pixel apparatus 500, or the CF 709 in the pixel apparatus 700. Details are not described herein again.

In some embodiments, the COE-OC 610 may be similar to the COE-OC 214 in the pixel apparatus 200 or the COE-OC 314 in the pixel apparatus 300. Details are not described herein again.

In the pixel apparatus 600, the organic transition layer 607 may be disposed between the second encapsulation layer 606 and the CF 609, and the organic transition layer 607 is in contact with the CF 609, so that a distance between the EL 603 and the CF 609 can be shortened, display luminance of the pixel apparatus 600 can be improved, and luminance attenuation at a large angle of view can be reduced. In addition, there are no additional multi-layer insulation layers (for example, an organic or inorganic ILD layer or a TOE-OC layer) between the organic transition layer 607 and the CF 609, so that reliability of the pixel apparatus can be improved. In addition, in this embodiment of this application, a thickness of the pixel apparatus 600 can be reduced, and a quantity of optical masks can be reduced in a preparation process for the pixel apparatus 600, to reduce preparation costs.

In some embodiments, a thickness of the TFT-BP 601 approximately ranges from 20 micrometers to 30 micrometers. A thickness of the PDL 602 approximately ranges from 1.5 micrometers to 2.5 micrometers. A thickness range of the EL 603 is approximately 10 nanometers (nm). Thicknesses of the first encapsulation layer 604 and the second encapsulation layer 606 approximately range from 0.8 micrometer to 1.2 micrometers. A thickness of the organic layer 605 approximately ranges from 8 micrometers to 12 micrometers. A thickness of the organic transition layer 607 approximately ranges from 1 micrometer to 2 micrometers. Thicknesses of the CF-BM 608 and the CF 609 approximately range from 1.5 micrometers to 2 micrometers. A thickness of the COE-OC 610 approximately ranges from 2 micrometers to 3 micrometers. That is, a thickness of the pixel apparatus 600 approximately ranges from 35.6 micrometers to 53.9 micrometers.

In some embodiments, the distance between the EL 603 and the CF 609 in the pixel apparatus 600 approximately ranges from 12.6 micrometers to 18.9 micrometers. Compared with a thickness of the pixel apparatus 300, the thickness of the pixel apparatus 600 may be reduced by approximately 3 micrometers to 5 micrometers.

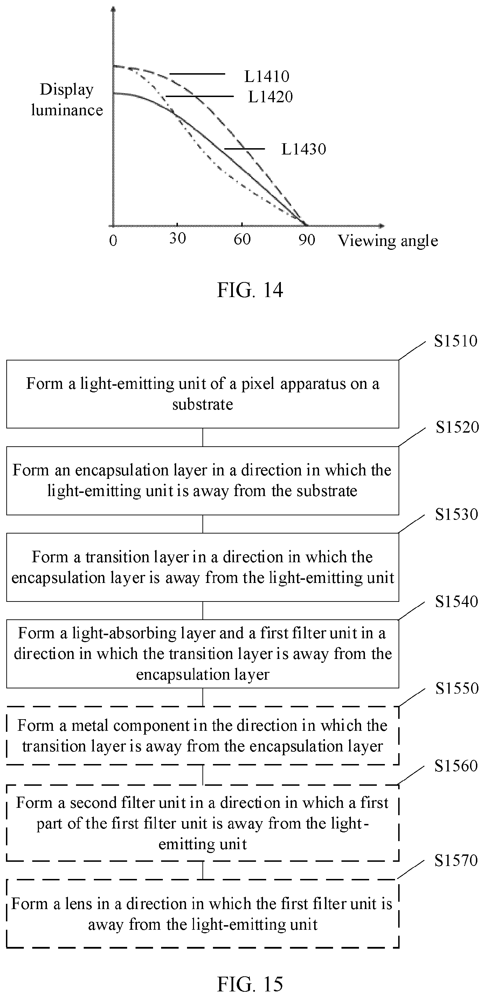

In some embodiments, light exit efficiency of the pixel apparatus 600 at a large angle of view can be improved by approximately 10%. The large angle of view of the pixel apparatus 600 is an angle greater than 30 degrees among viewing angles, to be specific, a viewing angle at which an included angle between a vertical normal direction or a horizontal normal direction of the pixel apparatus 600 and a direction in which the pixel apparatus 600 is located is greater than 30 degrees. The light exit efficiency of the pixel apparatus 600 at the large angle of view may be an integral of a display luminance curve of the pixel apparatus 600 within a range of the large angle of view. For example, the light exit efficiency of the pixel apparatus 600 at the large angle of view is an integral of L1410 at a viewing angle within a range of 30 to 90 in FIG. 14. It can be learned from FIG. 14 that the integral of L1410 at the viewing angle within the range of 30 to 90 is increased by approximately 5% compared with an integral of L1430. L1430 is a display luminance curve of the pixel apparatus 300. The viewing angle in FIG. 14 is an angle from the vertical normal direction or the horizontal normal direction to one side of the pixel apparatus. Therefore, at a large angle of view on another side of the pixel apparatus, an integral of L1410 at a viewing angle within a range of 30 to 90 is increased by approximately 5% compared with an integral of L1430. That is, the light exit efficiency of the pixel apparatus 600 at the large angle of view can be improved by approximately 10%.

In some embodiments, one or two optical masks may be omitted during preparation of the pixel apparatus 600, to reduce preparation costs.

FIG. 7 is a diagram of a structure of a pixel apparatus according to another embodiment of this application. The pixel apparatus 700 in FIG. 7 includes all structures of the pixel apparatus 600 in FIG. 6 other than the COE-OC 610, and a lens 710. To be specific, a TFT-BP 701, a PDL 702, an EL 703, a first encapsulation layer 704, an organic layer 705, a second encapsulation layer 706, an organic transition layer 707, a CF-BM 708, and a CF 709 included in the pixel apparatus 700 are similar to corresponding structures in the pixel apparatus 600. Details are not described herein again.

It should be understood that the CF 709 in FIG. 7 may be a thin film in any color in the CF 122 in FIG. 1. To be specific, one thin film in the CF 122 is used as an example for description in FIG. 7.

In some embodiments, the pixel apparatus 700 includes any one or more of the following: at least one EL 703, at least one CF 709, and at least one lens 710.

In some embodiments, the pixel apparatus 700 includes a light-emitting structure, a TFE structure, and a CF+TP+lens. The CF+TP+lens may also be referred to as a COE+TOE+lens. The light-emitting structure includes the TFT-BP 701, the PDL 702, and the EL 703. The TFE structure includes the first encapsulation layer 704, the organic layer 705, and the second encapsulation layer 706. The CF+TP structure includes the organic transition layer 707, the CF-BM 708, the CF 709, and the lens 710.

In some embodiments, the lens 710 may be configured to focus light. A height of the lens 710 relative to the TFT-BP 701 is higher than a height of the CF-BM 708 and a height of the CF 709 relative to the TFT-BP 701. The lens 710 includes an organic insulation material. The lens 710 is disposed in a direction in which the CF 709 is away from the TFT-BP 701, and the insulation material in the lens 710 may be in contact with a second surface of the CF 709. In other words, the insulation material in the lens 710 may be in contact with a part of a second surface of the CF-BM 708 and the second surface of the CF 709. During actual preparation, a height layer at which the lens 710 is located is higher than height layers at which the CF-BM 708 and the CF 709 are located. A height of the height layer at which the lens 710 is located may be understood as the height of the lens 710 relative to the TFT-BP 701.

In some embodiments, the lens 710 may be similar to the lens 414 in the pixel apparatus 400 or the lens in the pixel apparatus 500. Details are not described herein again.

In some embodiments, a thickness of the lens 710 approximately ranges from 5 micrometers to 10 micrometers. That is, a thickness of the pixel apparatus 700 approximately ranges from 38.6 micrometers to 60.9 micrometers.

Based on the advantages of the pixel apparatus 600, the lens 710 is added to the pixel apparatus 700 to achieve light focusing effect, so that axial luminance of the pixel apparatus 700 can be further improved without increasing power consumption of the pixel apparatus 700. The axial luminance of the pixel apparatus 700 is display luminance in a horizontal normal direction or a vertical normal direction of the pixel apparatus 700. In addition, because an optical distance between the EL 703 and the CF 709 in the pixel apparatus 700 is shortened, luminance attenuation of the pixel apparatus 700 at a large angle of view is reduced.

FIG. 8 is a diagram of a structure of a pixel apparatus according to an embodiment of this application. The pixel apparatus 800 in FIG. 8 includes a light-emitting unit 810, a connection layer 820, a first filter unit 830, a light-absorbing layer 840, and a metal component 850.

The light-emitting unit 810 is configured to emit light. The light-emitting unit 810 is similar to the light-emitting unit 510 in the pixel apparatus 500. Details are not described herein again.

The connection layer 820 is disposed between the light-emitting unit 810 and the first filter unit 830, and the connection layer 820 is in contact with the light-emitting unit 810 and the first filter unit 830.

In some embodiments, the connection layer 820 includes a first surface and a second surface. The first surface of the connection layer 820 is in contact with the light-emitting unit 810, and the second surface of the connection layer 820 is in contact with the first filter unit 830 and the light-absorbing layer 840.

In some embodiments, the connection layer 820 may include an organic insulation material and/or an inorganic insulation material, and the connection layer 820 is non-conductive. For example, the connection layer 820 may be made of resin and/or a silicide. This is not limited in this embodiment of this application.

In some embodiments, the connection layer 820 may include the first encapsulation layer 204, the organic layer 205, the second encapsulation layer 206, and the inorganic transition layer 207 of the pixel apparatus 200 in FIG. 2. Alternatively, the connection layer 820 may include the first encapsulation layer 304, the organic layer 305, the second encapsulation layer 306, and the organic transition layer 307 of the pixel apparatus 300 in FIG. 3. Alternatively, the connection layer 820 may include the first encapsulation layer 404, the organic layer 405, the second encapsulation layer 406, and the organic transition layer 407 of the pixel apparatus 400 in FIG. 4. Alternatively, the connection layer 820 may include the encapsulation layer 520 and the transition layer 530 of the pixel apparatus 500 in FIG. 5. Alternatively, the connection layer 820 may include the first encapsulation layer 604, the organic layer 605, the second encapsulation layer 606, and the organic transition layer 607 of the pixel apparatus 600 in FIG. 6. Alternatively, the connection layer 820 may include the first encapsulation layer 704, the organic layer 705, the second encapsulation layer 706, and the organic transition layer 707 of the pixel apparatus 700 in FIG. 7. This is not limited in this embodiment of this application.

In some embodiments, the connection layer 820 may include an encapsulation layer and a transition layer. The encapsulation layer is configured to protect the light-emitting unit 810. The encapsulation layer is disposed between the light-emitting unit 810 and the transition layer, and the encapsulation layer is in contact with the light-emitting unit 810 and the transition layer. The transition layer is disposed between the encapsulation layer and the first filter unit 830, and the transition layer is in contact with the encapsulation layer, the first filter unit 830, and the light-absorbing layer 840.

When the connection layer 820 includes the transition layer, the transition layer does not include a metal component.

In some embodiments, the transition layer includes an organic or inorganic insulation material. When the transition layer includes an inorganic material, a thickness of the transition layer ranges from 0.25 micrometers to 0.35 micrometers. When the transition layer includes an organic material, a thickness of the transition layer ranges from 1 micrometer to 2 micrometers.

In some embodiments, the encapsulation layer is similar to the encapsulation layer 520 in the pixel apparatus 500. The transition layer is similar to the transition layer 530 in the pixel apparatus 500.

The first filter unit 830 is disposed in a direction in which the connection layer 820 is away from the light-emitting unit 810, and the first filter unit 830 is in contact with the connection layer 820 and the light-absorbing layer 840. The first filter unit 830 is similar to the first filter unit 540 in the pixel apparatus 500.

The light-absorbing layer 840 is disposed in a direction in which the connection layer 820 is away from the light-emitting unit 810. The light-absorbing layer 840 is disposed around the first filter unit 830, and the light-absorbing layer 840 is in contact with the first filter unit 830 and the connection layer 820. The light-absorbing layer 840 is similar to the light-absorbing layer 550 in the pixel apparatus 500.

A part or all of the metal component 850 is disposed in the light-absorbing layer 840 and/or the first filter unit 830.

It should be understood that, in FIG. 8, an example in which all of the metal component 850 is disposed in the light-absorbing layer 840 is used for description. In FIG. 9, an example in which all of a metal component 950 is disposed in a first filter unit 930 is used for description. Alternatively, a first part of the metal component may be disposed in the first filter unit, and a second part of the metal component may be disposed in the light-absorbing layer. This is not limited in this embodiment of this application.

An example in which all of the metal component 850 is disposed in the light-absorbing layer 840 is used below for description.

In some embodiments, the metal component 850 may include at least one surface, and each of the at least one surface may be in contact with a light-absorbing material in the light-absorbing layer 840. Alternatively, one or more of the at least one surface cannot be in contact with the light-absorbing material in the light-absorbing layer 840. This is not limited in this embodiment of this application.

For example, a first surface of the metal component 850 and a first surface of the light-absorbing layer 840 are at a same height relative to the light-emitting unit 810. To be specific, the first surface of the metal component 850 is not in contact with the light-absorbing material in the light-absorbing layer 840. The first surface of the metal component 850 is a surface of the metal component 850 that is close to the light-emitting unit 810. Alternatively, a height of the first surface of the metal component 850 relative to the light-emitting unit 810 is higher than a height of the first surface of the light-absorbing layer 840 relative to the light-emitting unit 810. To be specific, the first surface of the metal component 850 is in contact with the light-absorbing material in the light-absorbing layer 840. Alternatively, a height of the first surface of the metal component 850 relative to the light-emitting unit 810 is lower than a height of the first surface of the light-absorbing layer 840 relative to the light-emitting unit 810. To be specific, the first surface of the metal component 850 is not in contact with the light-absorbing material in the light-absorbing layer 840. This is not limited in this embodiment of this application.

For example, a height of a second surface of the metal component 850 relative to the light-emitting unit 810 is lower than a height of a second surface of the light-absorbing layer 840 relative to the light-emitting unit 810. To be specific, the second surface of the metal component 850 is in contact with the light-absorbing material in the light-absorbing layer 840. The second surface of the metal component 850 is a surface of the metal component 850 that is away from the light-emitting unit 810. Alternatively, the second surface of the metal component 850 and the second surface of the light-absorbing layer 840 are at a same height relative to the light-emitting unit 810. To be specific, the second surface of the metal component 850 is not in contact with the light-absorbing material in the light-absorbing layer 840. Alternatively, a height of the second surface of the metal component 850 relative to the light-emitting unit 810 is higher than a height of the second surface of the light-absorbing layer 840 relative to the light-emitting unit 810. To be specific, the second surface of the metal component 850 is not in contact with the light-absorbing material in the light-absorbing layer 840. This is not limited in this embodiment of this application.

For example, a third surface of the metal component 850 is in direct contact with the first filter unit 830. To be specific, the third surface of the metal component 850 is not in contact with the light-absorbing material in the light-absorbing layer 840. The third surface of the metal component 850 is a surface of the metal component 850 that is close to the first filter unit 830. Alternatively, the third surface of the metal component 850 is not in contact with the first filter unit 830. To be specific, the third surface of the metal component 850 is in contact with the light-absorbing material in the light-absorbing layer 840. This is not limited in this embodiment of this application.

In some embodiments, the metal component 850 may include a first metal layer and a second metal layer. A part or all of the first metal layer may be located in the first filter unit 830 and/or the light-absorbing layer 840. A part or all of the second metal layer may be located in the first filter unit 830 and/or the light-absorbing layer 840.

In some embodiments, a height of a first surface of the first metal layer relative to the light-emitting unit is lower than a first height, and the first height is a height of a first surface of the second metal layer relative to the light-emitting unit. The first surface of the first metal layer is a surface of the first metal layer that is close to the light-emitting unit. The first surface of the second metal layer is a surface of the second metal layer that is close to the light-emitting unit.

In some embodiments, a height of a second surface of the first metal layer is lower than a height of the first surface of the second metal layer. The second surface of the first metal layer is a surface of the first metal layer that is away from the light-emitting unit 810. The height of the second surface of the first metal layer may be understood as a height of the second surface of the first metal layer relative to the light-emitting unit 810. The height of the first surface of the second metal layer may be understood as a height of the first surface of the second metal layer relative to the light-emitting unit 810. Alternatively, a height of the second surface of the first metal layer is higher than a height of the first surface of the second metal layer. Alternatively, a height of the second surface of the first metal layer is the same as a height of the first surface of the second metal layer. This is not limited in this embodiment of this application.

In some embodiments, the first metal layer and the second metal layer may be electrically connected. To be specific, the first metal layer and the second metal layer are mutually conductive.

In some embodiments, the light-absorbing material in the light-absorbing layer 840 is applied between the first metal layer and the second metal layer. To be specific, the first metal layer and the second metal layer are mutually non-conductive.

In some embodiments, the first metal layer and the second metal layer may include at least one surface, and each of the at least one surface may be in contact with the light-absorbing material in the light-absorbing layer 840. Alternatively, one or more of the at least one surface cannot be in contact with the light-absorbing material in the light-absorbing layer 840. This is not limited in this embodiment of this application.

For example, a first surface of the first metal layer and the first surface of the light-absorbing layer 840 are at a same height relative to the light-emitting unit 810. To be specific, the first surface of the first metal layer is not in contact with the light-absorbing material in the light-absorbing layer 840. The first surface of the first metal layer is a surface of the first metal layer that is close to the light-emitting unit 810. Alternatively, a height of the first surface of the first metal layer relative to the light-emitting unit 810 is higher than the height of the first surface of the light-absorbing layer 840 relative to the light-emitting unit 810. To be specific, the first surface of the first metal layer is in contact with the light-absorbing material in the light-absorbing layer 840. Alternatively, a height of the first surface of the first metal layer relative to the light-emitting unit 810 is lower than the height of the first surface of the light-absorbing layer 840 relative to the light-emitting unit 810. To be specific, the first surface of the first metal layer is not in contact with the light-absorbing material in the light-absorbing layer 840. This is not limited in this embodiment of this application.

For example, a height of a second surface of the second metal layer relative to the light-emitting unit 810 is lower than the height of the second surface of the light-absorbing layer 840 relative to the light-emitting unit 810. To be specific, the second surface of the second metal layer is in contact with the light-absorbing material in the light-absorbing layer 840. The second surface of the second metal layer is a surface of the second metal layer that is away from the light-emitting unit 810. Alternatively, the second surface of the second metal layer and the second surface of the light-absorbing layer 840 are at a same height relative to the light-emitting unit 810. To be specific, the second surface of the second metal layer is not in contact with the light-absorbing material in the light-absorbing layer 840. Alternatively, a height of the second surface of the second metal layer relative to the light-emitting unit 810 is higher than the height of the second surface of the light-absorbing layer 840 relative to the light-emitting unit 810. To be specific, the second surface of the second metal layer is not in contact with the light-absorbing material in the light-absorbing layer 840. This is not limited in this embodiment of this application.

For example, a third surface of the first metal layer and/or a third surface of the second metal layer are/is in direct contact with the first filter unit 830. To be specific, the third surface of the first metal layer and/or the third surface of the second metal layer are/is not in contact with the light-absorbing material in the light-absorbing layer 840. The third surface of the first metal layer and/or the third surface of the second metal layer are/is surfaces and/or a surface of the first metal layer and/or the second metal layer that are/is close to the first filter unit 830. Alternatively, the third surface of the first metal layer and/or the third surface of the second metal layer are/is not in contact with the first filter unit 830. To be specific, the third surface of the first metal layer and/or the third surface of the second metal layer are/is in contact with the light-absorbing material in the light-absorbing layer 840. This is not limited in this embodiment of this application.

In some embodiments, the metal component 850 may be a metal wire. When the metal component 850 includes the first metal layer and the second metal layer, the first metal layer and the second metal layer may be metal wires.

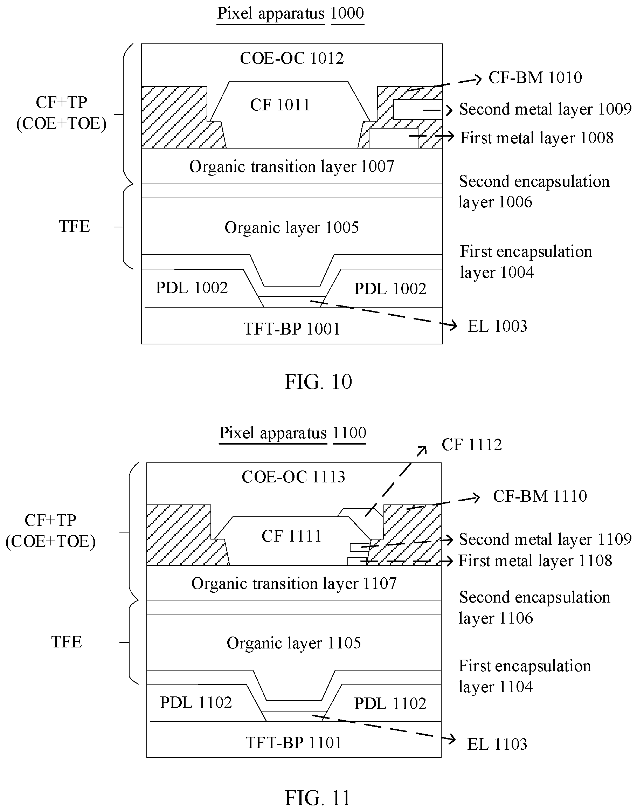

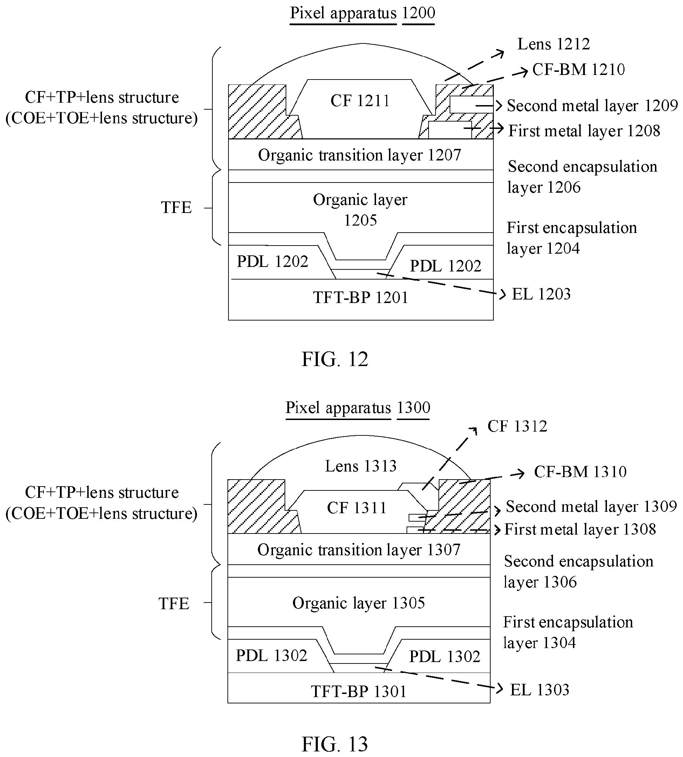

In some embodiments, the metal component 850 may be similar to the first metal layer 208 and/or the second metal layer 210 of the pixel apparatus 200 in FIG. 2. Alternatively, the metal component 850 may be similar to the first metal layer 308 and/or the second metal layer 310 of the pixel apparatus 300 in FIG. 3. Alternatively, the metal component 850 may be similar to the first metal layer 408 and/or the second metal layer 410 of the pixel apparatus 400 in FIG. 4. Alternatively, the metal component 850 may be similar to the metal component of the pixel apparatus 500 of FIG. 5. Alternatively, the metal component 850 may be similar to a first metal layer 1008 and/or a second metal layer 1009 of a pixel apparatus 1000 in FIG. 10. Alternatively, the metal component 850 may be similar to a first metal layer 1208 and/or a second metal layer 1209 of a pixel apparatus 1200 in FIG. 12.

When the metal component 840 includes the first metal layer and the second metal layer, the first metal layer may be similar to the first metal layer 208 in the pixel apparatus 200, the first metal layer 308 in the pixel apparatus 300, the first metal layer 408 in the pixel apparatus 400, the first metal layer 1008 in the pixel apparatus 1000, or the first metal layer 1208 in the pixel apparatus 1200, and the second metal layer may be similar to the second metal layer 210 in the pixel apparatus 200, the second metal layer 310 in the pixel apparatus 300, the second metal layer 410 in the pixel apparatus 400, the second metal layer 1009 in the pixel apparatus 1000, or the second metal layer 1209 in the pixel apparatus 1200.

In some embodiments, the pixel apparatus 800 may further include a lens. The lens is disposed in a direction in which the first filter unit 830 is away from the light-emitting unit 810.

In some embodiments, a height of a first surface of the lens relative to the light-emitting unit 810 is higher than a second height, and the second height is a height of a first surface of the first filter unit 830 relative to the light-emitting unit 810. The first surface of the lens is a surface of the lens that is close to the light-emitting unit 810. In addition, the height of the first surface of the lens relative to the light-emitting unit 810 is higher than the height of the first surface of the light-absorbing layer 840 relative to the light-emitting unit 810.

In some embodiments, the first surface of the lens is in contact with a part or all of a second surface of the first filter unit 830. Alternatively, the first surface of the lens is in contact with a part of the second surface of the light-absorbing layer 840 and a part or all of the second surface of the first filter unit 830.

In some embodiments, an insulation material may be applied between the first surface of the lens and the second surface of the first filter unit 830, and the insulation material may be configured to protect the first filter unit 830. To be specific, the first surface of the lens is partially in contact with or completely not in contact with the second surface of the first filter unit 830. Similarly, the first surface of the lens is partially in contact with or completely not in contact with a part of the second surface of the light-absorbing layer 840 and the second surface of the first filter unit 830.

In some embodiments, the lens may include an organic or inorganic insulation material, and the lens is non-conductive. For example, the lens may be made of resin or a silicide. This is not limited in this embodiment of this application.

In some embodiments, the pixel apparatus 800 may include at least one first filter unit 830 and at least one lens. The at least one first filter unit 830 is in a one-to-one correspondence with the at least one lens, and each lens may be configured to assist a corresponding first filter unit 830 in light focusing.

In some embodiments, the lens may be similar to the lens 414 of the pixel apparatus 400 in FIG. 4, the lens 710 in FIG. 7, or a lens 1212 in FIG. 12. This is not limited in this embodiment of this application.

In some embodiments, the pixel apparatus 800 may include any one or more of the following: at least one light-emitting unit 810, at least one first filter unit 830, at least one metal component 850, and at least one lens.

In the pixel apparatus 800, the metal component 850 may be disposed in the light-absorbing layer 840, so that no additional multi-layer insulation layers (for example, the TOE-OC and the organic or inorganic ILD layer in FIG. 2 to FIG. 4) need to be disposed between the light-absorbing layer 840 and the light-emitting unit 810 for placing the metal component 850 at the insulation layer. Therefore, peeling, cracking, or other problems caused by an inorganic ILD layer can be avoided in the pixel apparatus 800, to improve reliability of the pixel apparatus 800. In addition, in the pixel apparatus 800, the light-absorbing layer 840 may be reused, to shorten an optical distance between the light-emitting unit 810 and the first filter unit 830 in the pixel apparatus 800, and further improve luminance of light emitted by the pixel apparatus 800 and reduce luminance attenuation at a large angle of view. In addition, in this embodiment of this application, a thickness of the pixel apparatus 800 can be reduced, and a quantity of optical masks can be reduced in a preparation process for the pixel apparatus 800, to reduce preparation costs.

FIG. 9 is a diagram of a structure of a pixel apparatus according to an embodiment of this application. The pixel apparatus 900 in FIG. 9 includes a light-emitting unit 910, a connection layer 920, a first filter unit 930, a light-absorbing layer 940, a metal component 950, and a second filter unit 960.

The light-emitting unit 910, the connection layer 920, the first filter unit 930, and the light-absorbing layer 940 in the pixel apparatus 900 are similar to corresponding structures in the pixel apparatus 800. Details are not described herein again.

All or a part of the metal component 950 is disposed in a first part of the first filter unit 930. The first part of the first filter unit 930 is an edge part of the first filter unit 930 that is close to the light-absorbing layer 940.

In some embodiments, the metal component 950 may include at least one surface, and each of the at least one surface may be in contact with an insulation material in the first filter unit 930. Alternatively, one or more of the at least one surface cannot be in contact with the insulation material in the first filter unit 930. This is not limited in this embodiment of this application.

For example, a first surface of the metal component 950 and a first surface of the first filter unit 930 are at a same height relative to the light-emitting unit 910. To be specific, the first surface of the metal component 950 is not in contact with the insulation material in the first filter unit 930. The first surface of the metal component 950 is a surface of the metal component 950 that is close to the light-emitting unit 910. Alternatively, a height of the first surface of the metal component 950 relative to the light-emitting unit 910 is higher than a height of the first surface of the first filter unit 930 relative to the light-emitting unit 910. To be specific, the first surface of the metal component 950 is in contact with the insulation material in the first filter unit 930. Alternatively, a height of the first surface of the metal component 950 relative to the light-emitting unit 910 is lower than a height of the first surface of the first filter unit 930 relative to the light-emitting unit 910. To be specific, the first surface of the metal component 950 is not in contact with the insulation material in the first filter unit 930. This is not limited in this embodiment of this application.

For example, a height of a second surface of the metal component 950 relative to the light-emitting unit 910 is lower than a height of a second surface of the first filter unit 930 relative to the light-emitting unit 910. To be specific, the second surface of the metal component 950 is in contact with the insulation material in the first filter unit 930. The second surface of the metal component 950 is a surface of the metal component 950 that is away from the light-emitting unit 910. Alternatively, the second surface of the metal component 950 and the second surface of the first filter unit 930 are at a same height relative to the light-emitting unit 910. To be specific, the second surface of the metal component 950 is not in contact with the insulation material in the first filter unit 930. Alternatively, a height of the second surface of the metal component 950 relative to the light-emitting unit 910 is higher than a height of a second surface of the light-absorbing layer 940 relative to the light-emitting unit 910. To be specific, the second surface of the metal component 950 is not in contact with the insulation material in the first filter unit 930. This is not limited in this embodiment of this application.

For example, a third surface of the metal component 950 is in direct contact with the light-absorbing layer 940. To be specific, the third surface of the metal component 950 is not in contact with the insulation material in the first filter unit 930. The third surface of the metal component 950 is a surface of the metal component 950 that is close to the light-absorbing layer 940. Alternatively, the third surface of the metal component 950 is not in contact with the light-absorbing layer 940. To be specific, the third surface of the metal component 950 is in contact with the insulation material in the first filter unit 930. This is not limited in this embodiment of this application.

In some embodiments, the metal component 950 may include a first metal layer and a second metal layer. A part or all of the first metal layer may be located in the first filter unit 930 and/or the light-absorbing layer 940. A part or all of the second metal layer may be located in the first filter unit 930 and/or the light-absorbing layer 940.

In some embodiments, a height of a first surface of the first metal layer relative to the light-emitting unit is lower than a first height, and the first height is a height of a first surface of the second metal layer relative to the light-emitting unit. The first surface of the first metal layer is a surface of the first metal layer that is close to the light-emitting unit. The first surface of the second metal layer is a surface of the second metal layer that is close to the light-emitting unit.

In some embodiments, the first metal layer and the second metal layer may be electrically connected. To be specific, the first metal layer and the second metal layer are mutually conductive.

In some embodiments, the insulation material in the first filter unit 930 is applied between the first metal layer and the second metal layer. To be specific, the first metal layer and the second metal layer are mutually non-conductive.

In some embodiments, a location relationship between the first metal layer and the second metal layer is similar to the location relationship between the first metal layer and the second metal layer in the pixel apparatus 800. Details are not described herein again.

In some embodiments, a location relationship between the first metal layer and the first filter unit 930 is similar to the location relationship between the first metal layer and the light-absorbing layer 840 in the pixel apparatus 800. Details are not described herein again. A location relationship between the second metal layer and the first filter unit 930 is similar to the location relationship between the second metal layer and the light-absorbing layer 840 in the pixel apparatus 800. Details are not described herein again.

In some embodiments, the metal component 950 may be a metal wire. When the metal component 950 includes the first metal layer and the second metal layer, the first metal layer and the second metal layer may be metal wires.

The second filter unit 960 is disposed in a direction in which the first part of the first filter unit 930 is away from the light-emitting unit 910. The second filter unit 960 is in contact with the first part of the first filter unit 930, and a color of the second filter unit 960 is different from a color of the first filter unit 930.

In some embodiments, the second filter unit 960 may be in contact with the first filter unit 930 and the light-absorbing layer 940.

In some embodiments, the second filter unit 960 may include an organic or inorganic insulation material, and is non-conductive. For example, the second filter unit 960 may be made of resin or a silicide. This is not limited in this embodiment of this application. The insulation material included in the second filter unit 960 may be the same as or different from the insulation material included in the first filter unit 930. This is not limited in this embodiment of this application.

In some embodiments, the pixel apparatus 900 may include at least one first filter unit 930 and at least one second filter unit 960. The at least one first filter unit 930 is in a one-to-one correspondence with the at least one second filter unit 960. Each first filter unit 930 may be in any one of three primary colors, and a second filter unit 960 corresponding to the first filter unit 930 may be in either of the other two colors among the three primary colors, to prevent external light from being reflected out of the pixel apparatus 900 by the metal component 950.

In the pixel apparatus 900, the metal component 950 may be disposed in the first filter unit 930, so that no additional multi-layer insulation layers (for example, the TOE-OC and the organic or inorganic ILD layer in FIG. 2 to FIG. 4) need to be disposed between the light-absorbing layer 940 and the light-emitting unit 910 for placing the metal component 950 at the insulation layer. Therefore, peeling, cracking, or other problems caused by an inorganic ILD layer can be avoided in the pixel apparatus 900, to improve reliability of the pixel apparatus 900. In addition, in the pixel apparatus 900, the first filter unit 930 may be reused, to shorten an optical distance between the light-emitting unit 910 and the first filter unit 930 in the pixel apparatus 900, and further improve luminance of light emitted by the pixel apparatus 900 and reduce luminance attenuation at a large angle of view. In addition, in this embodiment of this application, a thickness of the pixel apparatus 900 can be reduced, and a quantity of optical masks can be reduced in a preparation process for the pixel apparatus 900, to reduce preparation costs.

FIG. 10 is a diagram of a structure of a pixel apparatus according to another embodiment of this application. The pixel apparatus 1000 in FIG. 10 includes a TFT-BP 1001, a PDL 1002, an EL 1003, a first encapsulation layer 1004, an organic layer 1005, a second encapsulation layer 1006, an organic transition layer 1007, a first metal layer 1008, a second metal layer 1009, a CF-BM 1010, a CF 1011, and a COE-OC 1012. In other words, the pixel apparatus 1000 includes all structures in the pixel apparatus 600, the first metal layer 1008, and the second metal layer 1009.

The TFT-BP 1001, the PDL 1002, the EL 1003, the first encapsulation layer 1004, the organic layer 1005, the second encapsulation layer 1006, the organic transition layer 1007, the CF-BM 1010, the CF 1011, and the COE-OC 1012 are similar to corresponding structures in the pixel apparatus 600. Details are not described herein again.

In some embodiments, the first metal layer 1008 is a metal electrode of a touch sensor in the pixel apparatus 1000. The first metal layer 1008 is disposed in the CF-BM 1010. A first surface of the first metal layer 1008 is in contact with the organic transition layer 1007. To be specific, the first surface of the first metal layer 1008 and a first surface of the CF-BM 1010 are at a same height relative to the TFT-BP 1001. To be specific, the first surface of the first metal layer 1008 is not in contact with a light-absorbing material in the CF-BM 1010, and a surface of the first metal layer 1008 other than the first surface is in contact with the light-absorbing material in the CF-BM 1010. During actual preparation, a height layer at which the first metal layer 1008 is located is higher than a height layer at which the organic transition layer 1007 is located. A height of the height layer at which the first metal layer 1008 is located may be understood as a height of the first metal layer 1008 relative to the TFT-BP 1001.

In some embodiments, the second metal layer 1009 is a metal electrode of the touch sensor in the pixel apparatus 1000. The second metal layer 1009 is disposed in the CF-BM 1010, and each surface of the second metal layer 1009 is in contact with the light-absorbing material in the CF-BM 1010. During actual preparation, a height layer at which the second metal layer 1009 is located is higher than the height layer at which the first metal layer 1008 is located. A height of the height layer at which the second metal layer 1009 is located may be understood as a height of the second metal layer 1009 relative to the TFT-BP 1001.

In some embodiments, the first metal layer 1008 may be similar to the first metal layer 208 in the pixel apparatus 200, the first metal layer 308 in the pixel apparatus 300, the first metal layer 408 in the pixel apparatus 400, or the first metal layer in the pixel apparatus 800. Details are not described herein again.

In some embodiments, the second metal layer 1009 may be similar to the second metal layer 210 in the pixel apparatus 200, the second metal layer 310 in the pixel apparatus 300, the second metal layer 410 in the pixel apparatus 400, or the second metal layer in the pixel apparatus 800. Details are not described herein again.

In some embodiments, the first metal layer 1008 may be the metal component 850 of the pixel apparatus 800 in FIG. 8. Alternatively, the second metal layer 1009 may be the metal component 850 of the pixel apparatus 800 in FIG. 8. Alternatively, the first metal layer 1008 and the second metal layer 1009 may be the metal component 850 of the pixel apparatus 800 in FIG. 8. This is not limited in this embodiment of this application.

In the pixel apparatus 1000, the first metal layer 1008 and the second metal layer 1009 may be disposed in the CF-BM 1010. No inorganic ILD layer or organic ILD layer needs to be disposed between the CF-BM 1010 and the EL 1003 for placing the first metal layer 1008, and no TOE-OC needs to be disposed for placing the second metal layer 1009 either. Therefore, peeling, cracking, or other problems caused by an inorganic ILD layer can be avoided in the pixel apparatus 1000, to improve reliability of the pixel apparatus 1000. In addition, in the pixel apparatus 1000, the CF-BM 1010 may be reused, to shorten an optical distance between the EL 1003 and the CF 1011 in the pixel apparatus 1000, and further improve luminance of light emitted by the pixel apparatus 1000 and reduce luminance attenuation at a large angle of view. In addition, in this embodiment of this application, a thickness of the pixel apparatus 1000 can be reduced, and a quantity of optical masks can be reduced in a preparation process for the pixel apparatus 1000, to reduce preparation costs.

FIG. 11 is a diagram of a structure of a pixel apparatus according to another embodiment of this application. The pixel apparatus 1100 in FIG. 11 includes all structures in the pixel apparatus 1000, and a CF 1112. To be specific, the pixel apparatus 1100 includes a TFT-BP 1101, a PDL 1102, an EL 1103, a first encapsulation layer 1104, an organic layer 1105, a second encapsulation layer 1106, an organic transition layer 1107, a first metal layer 1108, a second metal layer 1109, a CF-BM 1110, a CF 1111, the CF 1112, and a COE-OC 1113. Structures in the pixel apparatus 1100 other than the first metal layer 1108, the second metal layer 1109, and the CF 1112 are similar to corresponding structures in the pixel apparatus 1000.

The first metal layer 1108 is a metal electrode of a touch sensor in the pixel apparatus 1100. The first metal layer 1108 is disposed in a first part of the CF 1111, and the first part of the CF 1111 is an edge part of the CF 1111 that is close to the CF-BM 1110. A first surface of the first metal layer 1108 is in contact with the organic transition layer 1107. To be specific, the first surface of the first metal layer 1108 and a first surface of the CF 1111 are at a same height relative to the TFT-BP 1101. To be specific, the first surface of the first metal layer 1108 is not in contact with an insulation material in the CF 1111, and a surface of the first metal layer 1108 other than the first surface is in contact with the insulation material in the CF 1111. During actual preparation, a height layer at which the first metal layer 1108 is located is higher than a height layer at which the organic transition layer 1107 is located. A height of the height layer at which the first metal layer 1108 is located may be understood as a height of the first metal layer 1108 relative to the TFT-BP 1101.

The second metal layer 1109 is a metal electrode of the touch sensor in the pixel apparatus 1100. The second metal layer 1109 is disposed in the first part of the CF 1111, and the first part of the CF 1111 is an edge part of the CF 1111 that is close to the CF-BM 1110. Each surface of the second metal layer 1109 is in contact with the insulation material in the CF 1111. During actual preparation, a height layer at which the second metal layer 1109 is located is higher than the height layer at which the first metal layer 1108 is located. A height of the height layer at which the second metal layer 1109 is located may be understood as a height of the second metal layer 1109 relative to the TFT-BP 1101.

In some embodiments, the first metal layer 1108 may be similar to the first metal layer 208 in the pixel apparatus 200, the first metal layer 308 in the pixel apparatus 300, the first metal layer 408 in the pixel apparatus 400, or the first metal layer in the pixel apparatus 900. Details are not described herein again.

In some embodiments, the second metal layer 1109 may be similar to the second metal layer 210 in the pixel apparatus 200, the second metal layer 310 in the pixel apparatus 300, the second metal layer 410 in the pixel apparatus 400, or the second metal layer in the pixel apparatus 900. Details are not described herein again.

In some embodiments, the first metal layer 1108 may be the metal component 950 of the pixel apparatus 900 in FIG. 9. Alternatively, the second metal layer 1109 may be the metal component 950 of the pixel apparatus 900 in FIG. 9. Alternatively, the first metal layer 1108 and the second metal layer 1109 may be the metal component 950 of the pixel apparatus 900 in FIG. 9. This is not limited in this embodiment of this application.

The CF 1112 is disposed in a direction in which the first part of the CF 1111 is away from the light-emitting unit, and is in contact with the first part of the CF 1111. The CF 1112 may be further in contact with the CF-BM 1110. The first part of the CF 1111 is an edge part of the CF 1111 that is close to the CF-BM 1110. During actual preparation, a height layer at which the CF 1112 is located is higher than a height layer at which the CF 1111 is located. A height of the height layer at which the CF 1112 is located may be understood as a height of the CF 1112 relative to the TFT-BP 1101.

In some embodiments, the CF 1112 is similar to the second filter unit 960 in the pixel apparatus 900.

In the pixel apparatus 1100, the first metal layer 1108 and the second metal layer 1109 may be disposed in the CF 1111. No inorganic ILD layer or organic ILD layer needs to be disposed between the CF 1111 and the EL 1103 for placing the first metal layer 1108, and no TOE-OC needs to be disposed for placing the second metal layer 1109 either. Therefore, peeling, cracking, or other problems caused by an inorganic ILD layer can be avoided in the pixel apparatus 1100, to improve reliability of the pixel apparatus 1100. In addition, in the pixel apparatus 1100, the CF 1111 may be reused, to shorten an optical distance between the EL 1103 and the CF 1111 in the pixel apparatus 1100, and further improve luminance of light emitted by the pixel apparatus 1100 and reduce luminance attenuation at a large angle of view. In addition, in this embodiment of this application, a thickness of the pixel apparatus 1100 can be reduced, and a quantity of optical masks can be reduced in a preparation process for the pixel apparatus 1100, to reduce preparation costs.

FIG. 12 is a diagram of a structure of a pixel apparatus according to another embodiment of this application. The pixel apparatus 1200 in FIG. 12 includes all structures in the pixel apparatus 1000 other than the COE-OC 1012, and a lens 1212. To be specific, the pixel apparatus 1200 includes a TFT-BP 1201, a PDL 1202, an EL 1203, a first encapsulation layer 1204, an organic layer 1205, a second encapsulation layer 1206, an organic transition layer 1207, a first metal layer 1208, a second metal layer 1209, a CF-BM 1210, a CF 1211, and the lens 1212. Structures in the pixel apparatus 1200 other than the lens 1212 are similar to corresponding structures in the pixel apparatus 1000.

The lens 1212 may be configured to focus light. A height of the lens 1212 relative to the TFT-BP 1201 is higher than a height of the CF-BM 1210 and a height of the CF 1211 relative to the TFT-BP 1201. The lens 1212 includes an organic insulation material. The lens 1212 is disposed in a direction in which the CF 1211 is away from the TFT-BP 1201, and the insulation material in the lens 1212 may be in contact with a second surface of the CF 1211. In other words, the insulation material in the lens 1212 may be in contact with a part of a second surface of the CF-BM 1210 and the second surface of the CF 1211. During actual preparation, a height layer at which the lens 1212 is located is higher than height layers at which the CF-BM 1210 and the CF 1211 are located. A height of the height layer at which the lens 1212 is located may be understood as a height of the lens 1212 relative to the TFT-BP 1201.

In some embodiments, the lens 1212 may be similar to the lens 414 in the pixel apparatus 400 or the lens 710 in the pixel apparatus 700. Details are not described herein again.

In some embodiments, a thickness of the lens 1212 approximately ranges from 5 micrometers to 10 micrometers. That is, a thickness of the pixel apparatus 1200 approximately ranges from 38.6 micrometers to 60.9 micrometers.

Based on the advantages of the pixel apparatus 1000, the lens 1212 is added to the pixel apparatus 1200 to achieve light focusing effect, so that axial luminance of the pixel apparatus 1200 can be further improved without increasing power consumption of the pixel apparatus 1200. In addition, because an optical distance between the EL 1203 and the CF 1211 in the pixel apparatus 1200 is shortened, luminance attenuation of the pixel apparatus 1200 at a large angle of view is reduced.

FIG. 13 is a diagram of a structure of a pixel apparatus according to an embodiment of this application. The pixel apparatus 1300 in FIG. 13 includes all structures in the pixel apparatus 1100 other than the COE-OC 1113, and a lens 1313. To be specific, the pixel apparatus 1300 includes a TFT-BP 1301, a PDL 1302, an EL 1303, a first encapsulation layer 1304, an organic layer 1305, a second encapsulation layer 1306, an organic transition layer 1307, a first metal layer 1308, a second metal layer 1309, a CF-BM 1310, a CF 1311, a CF 1312, and the lens 1313. Structures in the pixel apparatus 1300 other than the lens 1313 are similar to corresponding structures in the pixel apparatus 1100.

The lens 1313 may be configured to focus light. A height of the lens 1313 relative to the TFT-BP 1301 is higher than a height of the CF-BM 1310, a height of the CF 1311, and a height of the CF 1312 relative to the TFT-BP 1301. The lens 1313 includes an organic insulation material. The lens 1313 is disposed in a direction in which the CF 1311 is away from the TFT-BP 1301, and the insulation material in the lens 1313 may be in contact with a second surface of the CF 1311. In other words, the insulation material in the lens 1313 may be in contact with a part of a second surface of the CF-BM 1310, the second surface of the CF 1311, and a part of a surface of the CF 1312. During actual preparation, a height layer at which the lens 1313 is located is higher than height layers at which the CF-BM 1310, the CF 1311, and the CF 1312 are located. A height of the height layer at which the lens 1313 is located may be understood as a height of the lens 1313 relative to the TFT-BP 1301.

In some embodiments, the lens 1313 may be similar to the lens 414 in the pixel apparatus 400, the lens 710 in the pixel apparatus 700, or the lens 1213 in the pixel apparatus 1200. Details are not described herein again.

Based on the advantages of the pixel apparatus 1100, the lens 1313 is added to the pixel apparatus 1300 to achieve light focusing effect, so that axial luminance of the pixel apparatus 1300 can be further improved without increasing power consumption of the pixel apparatus 1300. In addition, because an optical distance between the EL 1303 and the CF 1311 in the pixel apparatus 1300 is shortened, luminance attenuation of the pixel apparatus 1300 at a large angle of view is reduced.

FIG. 14 is a diagram of optical simulation of display luminance of different pixel apparatuses according to an embodiment of this application. FIG. 14 includes L1410, L1420, and L1430. In FIG. 14, a horizontal coordinate is a viewing angle, and a vertical coordinate is display luminance. L1410 represents a curve of display luminance of the pixel apparatus 1200 in FIG. 12 at different viewing angles. L1420 represents a curve of display luminance of the pixel apparatus 400 in FIG. 4 at different viewing angles. L1430 represents a curve of display luminance of the pixel apparatus 300 in FIG. 3 at different viewing angles.

It can be learned from FIG. 14 that, when a viewing angle is 0 degrees, display luminance of L1410 is close to display luminance of L1420, and the display luminance of L1410 is higher than display luminance of L1430. To be specific, axial luminance of the pixel apparatus 1200 is better than axial luminance of the pixel apparatus 300, and the axial luminance of the pixel apparatus 1200 is close to axial luminance of the pixel apparatus 400.

It can be learned from FIG. 14 that, when a viewing angle is greater than 30 degrees, display luminance of L1410 is higher than display luminance of L1420 and display luminance of L1430. To be specific, display luminance of the pixel apparatus 1200 at a large angle of view is better than display luminance of the pixel apparatus 300 and display luminance of the pixel apparatus 400 at a large angle of view.

It can be further learned from FIG. 14 that, when a viewing angle is greater than 30 degrees, a slope of L1410 is small, and slopes of L1420 and L1430 are large. To be specific, display luminance of L1410 slightly decreases with an increase in a viewing angle, and display luminance of L1420 and display luminance of L1430 greatly decrease with an increase in a viewing angle. To be specific, luminance attenuation of the pixel apparatus 1200 at a large angle of view is lower than luminance attenuation of the pixel apparatus 300 and luminance attenuation of the pixel apparatus 400 at a large angle of view.

FIG. 15 is a schematic flowchart of a pixel apparatus preparation method according to an embodiment of this application. The method in FIG. 15 includes the following steps.

S1510: Form a light-emitting unit of a pixel apparatus on a substrate.

The light-emitting unit of the pixel apparatus may be disposed on the substrate, in other words, may be disposed at a lowest height layer. To be specific, a height layer at which the light-emitting unit is located is lower than height layers at which an encapsulation layer, a transition layer, a light-absorbing layer, and a first filter unit are located.

Optionally, the light-emitting unit may be configured to emit light. The light-emitting unit may include an EL component, or the light-emitting unit may include an EL component and a PDL, or the light-emitting unit may include an EL component, a PDL, and a TFT-BP. This is not limited in this embodiment of this application. The light-emitting unit may be similar to the light-emitting unit 510 in FIG. 5.

S1520: Form the encapsulation layer in a direction in which the light-emitting unit is away from the substrate.

The encapsulation layer may be disposed in the direction in which the light-emitting unit is away from the substrate, and an insulation material in the encapsulation layer may be in contact with the light-emitting unit and the transition layer.

Optionally, the encapsulation layer may protect the light-emitting unit, and the encapsulation layer may include an organic or inorganic insulation material. The encapsulation layer may be similar to the encapsulation layer 520 of the pixel apparatus in FIG. 5.

S1530: Form the transition layer in a direction in which the encapsulation layer is away from the light-emitting unit.

The transition layer may be disposed in the direction in which the encapsulation layer is away from the light-emitting unit, and an insulation material in the transition layer may be in contact with the encapsulation layer and the first filter unit. To be specific, the transition layer is disposed between the encapsulation layer and the first filter unit.

Optionally, the transition layer does not include a metal component.

Optionally, the transition layer is similar to the transition layer 530 of the pixel apparatus in FIG. 5.

S1540: Form the light-absorbing layer and the first filter unit in a direction in which the transition layer is away from the encapsulation layer.

The light-absorbing layer is disposed in the direction in which the transition layer is away from the encapsulation layer. The light-absorbing layer is disposed around the first filter unit, and the light-absorbing layer is in contact with the transition layer and the first filter unit.

Optionally, the light-absorbing layer may include a first surface, a second surface, and a third surface. The first surface of the light-absorbing layer is a surface of the light-absorbing layer that is close to the light-emitting unit. The second surface of the light-absorbing layer is a surface of the light-absorbing layer that is away from the light-emitting unit. The third surface of the light-absorbing layer is a surface of the light-absorbing layer that is close to the first filter unit.

In some embodiments, a part or all of the third surface of the light-absorbing layer may be in contact with the first filter unit.

Optionally, the first surface of the light-absorbing layer and a first surface of the first filter unit may be at a same height relative to the light-emitting unit. In other words, the first surface of the light-absorbing layer and the first surface of the first filter unit are located at a same height. Alternatively, the first surface of the light-absorbing layer and the first surface of the first filter unit may be at different heights relative to the light-emitting unit. This is not limited in this embodiment of this application. The first surface of the first filter unit is a surface of the first filter unit that is close to the light-emitting unit.

Optionally, the light-absorbing layer may include an organic or inorganic light-absorbing material. The light-absorbing layer may be similar to the light-absorbing layer 550 in FIG. 5.

The first filter unit is disposed in the direction in which the transition layer is away from the encapsulation layer, and the first filter unit is in contact with the transition layer and the light-absorbing layer.

Optionally, the first filter unit includes the first surface, a second surface, and a third surface. The first surface of the first filter unit is a surface of the first filter unit that is close to the light-emitting unit. The second surface of the first filter unit is a surface of the first filter unit that is away from the light-emitting unit. The third surface of the first filter unit is a surface of the first filter unit that is close to the light-absorbing layer.

Optionally, the first surface of the first filter unit and the first surface of the light-absorbing layer may be at a same height or different heights relative to the light-emitting unit. This is not limited in this embodiment of this application.

Optionally, the first filter unit may include an organic or inorganic insulation material. The first filter unit may be similar to the first filter unit 540 in FIG. 5.

Optionally, a sequence of forming the light-absorbing layer and the first filter unit in the direction in which the transition layer is away from the encapsulation layer is not limited in this embodiment of this application. For example, the light-absorbing layer may be first formed in the direction in which the transition layer is away from the encapsulation layer, and then the first filter unit is formed. Alternatively, the first filter unit may be first formed in the direction in which the transition layer is away from the encapsulation layer, and then the light-absorbing layer is formed. Alternatively, the light-absorbing layer and the first filter unit may be simultaneously formed in the direction in which the transition layer is away from the encapsulation layer.

Optionally, the pixel apparatus may include at least one first filter unit, and each of the at least one first filter unit may be in any one of three primary colors. Therefore, during formation of the first filter unit, a first filter unit in a first color among the three primary colors may be first formed, and then a first filter unit in a second color among the three primary colors is formed, and finally, a first filter unit in a third color among the three primary colors is formed. The first color, the second color, and the third color are different colors among the three primary colors.

It should be understood that a sequence of forming the light-absorbing layer and the first filter units in the three colors is not specifically limited in this embodiment of this application. For example, the light-absorbing layer may be first formed, and then the first filter unit in the first color, the first filter unit in the second color, and the first filter unit in the third color are sequentially formed. Alternatively, the first filter unit in the first color may be first formed, and then the light-absorbing layer, the first filter unit in the second color, and the first filter unit in the third color are sequentially formed. Alternatively, the light-absorbing layer and the first filter units in the three colors may be formed in another order.

Optionally, after step S1540 is performed, step S1550, S1560, or S1570 may be further performed.

S1550: Form a metal component in the direction in which the transition layer is away from the encapsulation layer.

A part or all of the metal component is disposed in the light-absorbing layer and/or the first filter unit.

Optionally, the metal component may include at least one surface, and one or more of the at least one surface may be in contact with an insulation material in the light-absorbing layer and/or the insulation material in the first filter unit.

Optionally, the metal component may be a metal wire. The metal component may be similar to the metal component 850 in FIG. 8 or the metal component 950 in FIG. 9.

Optionally, a sequence of forming the light-absorbing layer, the first filter unit, and the metal component in the pixel apparatus is not limited in this embodiment of this application. For example, the metal component may be first formed, and then the light-absorbing layer is formed, and finally, the first filter unit is formed. Alternatively, the metal component may be first formed, and then the first filter unit is formed, and finally, the light-absorbing layer is formed. Alternatively, the light-absorbing layer, the first filter unit, and the metal component may be formed in another order.

Optionally, the metal component may include a first metal layer and a second metal layer. A part or all of the first metal layer is disposed in the light-absorbing layer and/or the first filter unit. A part or all of the second metal layer is disposed in the light-absorbing layer and/or the first filter unit.

Optionally, a height of a first surface of the first metal layer relative to the light-emitting unit is lower than a first height, and the first height is a height of a first surface of the second metal layer relative to the light-emitting unit.

In some embodiments, the insulation material in the light-absorbing layer and/or the insulation material in the first filter unit are/is applied between the first metal layer and the second metal layer. Alternatively, the first metal layer and the second metal layer are mutually conductive. This is not limited in this embodiment of this application.

Optionally, the first surface of the first metal layer, and the first surface of the light-absorbing layer and/or the first surface of the first filter unit have a same height relative to the light-emitting unit. The first surface of the first metal layer is a surface of the first metal layer that is close to the light-emitting unit. To be specific, the first surface of the first metal layer is not in contact with the insulation material in the light-absorbing layer and/or the insulation material in the first filter unit, and a surface of the first metal layer other than the first surface is in contact with the insulation material in the light-absorbing layer and/or the insulation material in the first filter unit.

Optionally, a part or all of surfaces of the second metal layer may be in contact with the insulation material in the light-absorbing layer and/or the insulation material in the first filter unit.

Optionally, the first metal layer and the second metal layer may be metal wires.

Optionally, the first metal layer may be similar to the first metal layer 1008 of the pixel apparatus 1000 in FIG. 10, the first metal layer 1108 of the pixel apparatus 1100 in FIG. 11, the first metal layer 1208 of the pixel apparatus 1200 in FIG. 12, or the first metal layer 1308 of the pixel apparatus 1300 in FIG. 13. The second metal layer may be similar to the second metal layer 1009 of the pixel apparatus 1000 in FIG. 10, the second metal layer 1109 of the pixel apparatus 1100 in FIG. 11, the second metal layer 1209 of the pixel apparatus 1200 in FIG. 12, or the second metal layer 1309 of the pixel apparatus 1300 in FIG. 13.

When the first metal layer and the second metal layer are disposed in the light-absorbing layer, a sequence of forming the light-absorbing layer, the first metal layer, and the second metal layer may be as follows: First, the first metal layer is formed in the direction in which the transition layer is away from the encapsulation layer. Next, a first part of the light-absorbing layer is formed in the direction in which the transition layer is away from the encapsulation layer. Then the second metal layer is formed in a direction in which the first part of the light-absorbing layer is away from the light-emitting unit. Finally, a second part of the light-absorbing layer is formed in the direction in which the first part of the light-absorbing layer is away from the light-emitting unit.

The first part of the light-absorbing layer includes a light-absorbing material and the first metal layer. The light-absorbing material in the first part of the light-absorbing layer may be in contact with at least one surface of the first metal layer. For example, the light-absorbing material in the first part of the light-absorbing layer may be in contact with a surface of the first metal layer other than the first surface. The first surface of the first metal layer is a surface of the first metal layer that is close to the light-emitting unit. The second part of the light-absorbing layer includes a light-absorbing material and the second metal layer. The light-absorbing material in the second part of the light-absorbing layer may be in contact with at least one surface of the second metal layer. For example, the light-absorbing material in the second part of the light-absorbing layer may be in contact with a surface of the second metal layer other than the first surface. The first surface of the second metal layer is a surface of the second metal layer that is close to the light-emitting unit. To be specific, all surfaces of the second metal layer may be in contact with the light-absorbing material in the first part or the second part of the light-absorbing layer.

It should be understood that the light-absorbing layer of the pixel apparatus is formed after the second part of the light-absorbing layer is formed.

When the first metal layer and the second metal layer are disposed in the light-absorbing layer, a sequence of forming the light-absorbing layer, the first metal layer, and the second metal layer may alternatively be as follows: First, the light-absorbing layer is formed in the direction in which the transition layer is away from the encapsulation layer. Then two through holes are formed in the light-absorbing layer, and the first metal layer and the second metal layer are formed in the two through holes.

When the first metal layer and the second metal layer are disposed in the first filter unit, a sequence of forming the first filter unit, the first metal layer, and the second metal layer is similar to the sequence of forming the light-absorbing layer, the first metal layer, and the second metal layer. Details are not described herein again.

When the first metal layer and/or the second metal layer are/is disposed in the first filter unit and the light-absorbing layer, a sequence of forming the first metal layer, the second metal layer, the first filter unit, and the light-absorbing layer is similar to the sequence of forming the light-absorbing layer, the first metal layer, and the second metal layer. Details are not described herein again.

Optionally, similar to the sequence of forming the light-absorbing layer, the first filter unit, and the metal component in the pixel apparatus, a sequence of forming the light-absorbing layer, the first filter unit, the first metal layer, and the second metal layer in the pixel apparatus is not limited in this embodiment of this application.

S1560: Form a second filter unit in a direction in which a first part of the first filter unit is away from the light-emitting unit.

The second filter unit is disposed in the direction in which the first part of the first filter unit is away from the light-emitting unit, and the second filter unit is in contact with the first part of the first filter unit. A color of the second filter unit is different from a color of the first filter unit. The first part of the first filter unit is an edge part of the first filter unit that is close to the light-absorbing layer.

Optionally, an insulation material included in the second filter unit may be the same as or different from the insulation material in the first filter unit. This is not limited in this embodiment of this application.

Optionally, the second filter unit is similar to the second filter unit 960 in FIG. 9, the CF 1112 in FIG. 11, or the CF 1312 in FIG. 13.

S1570: Form a lens in a direction in which the first filter unit is away from the light-emitting unit.

Optionally, a height of a first surface of the lens relative to the light-emitting unit is higher than a second height, and the second height is a height of the first surface of the first filter unit relative to the light-emitting unit. The first surface of the lens is a surface of the lens that is close to the light-emitting unit.

Optionally, the first surface of the lens is in contact with the second surface of the first filter unit. To be specific, the second surface of the first filter unit is in contact with an insulation material included in the lens. The first surface of the lens is a surface of the lens that is close to the light-emitting unit. The second surface of the first filter unit is a surface of the first filter unit that is away from the light-emitting unit. Alternatively, the first surface of the lens may be in contact with a part of the second surface of the light-absorbing layer, the second surface of the first filter unit, and a part of a surface of the second filter unit.

Optionally, an insulation material may be applied between the first surface of the lens and the second surface of the first filter unit, and the insulation material may be configured to protect the first filter unit. To be specific, the first surface of the lens is partially in contact with or completely not in contact with the second surface of the first filter unit. Similarly, the first surface of the lens may be partially in contact with or completely not in contact with a part of the second surface of the light-absorbing layer and the second surface of the first filter unit. The first surface of the lens may be partially in contact with or completely not in contact with a part of a surface of the second filter unit that is away from the light-emitting unit.

Optionally, the lens may be configured to focus light, and the lens may include an organic or inorganic insulation material. The lens may be similar to the lens 710 of the pixel apparatus 700 in FIG. 7, the lens 1212 of the pixel apparatus 1200 in FIG. 12, or the lens 1313 of the pixel apparatus 1300 in FIG. 13.

In this embodiment of this application, the transition layer may be disposed between the encapsulation layer and the first filter unit, and the transition layer is in contact with the first filter unit, so that a distance between the light-emitting unit and the first filter unit can be shortened, display luminance of the pixel apparatus can be improved, and luminance attenuation at a large angle of view can be reduced. In addition, there are no additional multi-layer insulation layers between the transition layer and the first filter unit, so that reliability of the pixel apparatus can be improved. In addition, in this embodiment of this application, a thickness of the pixel apparatus can be reduced, and a quantity of optical masks can be reduced in a preparation process for the pixel apparatus, to reduce preparation costs.

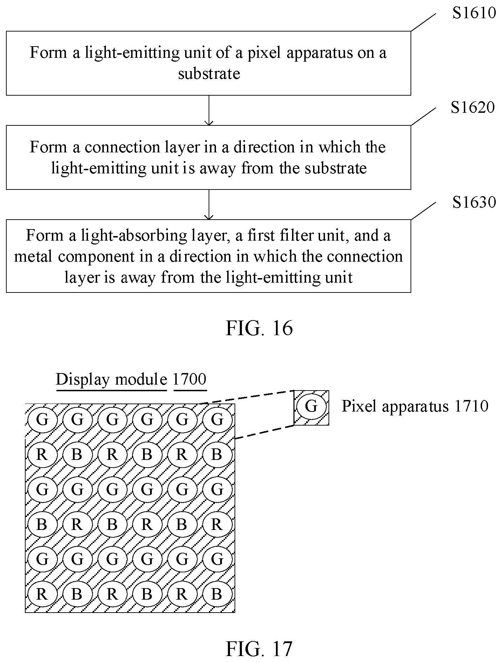

FIG. 16 is a schematic flowchart of a pixel apparatus preparation method according to an embodiment of this application. The method in FIG. 16 includes the following steps.

S1610: Form a light-emitting unit of a pixel apparatus on a substrate. Step S1610 is similar to step S1510. Details are not described herein again.

S1620: Form a connection layer in a direction in which the light-emitting unit is away from the substrate.

The connection layer is disposed between the light-emitting unit and a first filter unit, and the connection layer may be in contact with the light-emitting unit, the first filter unit, and a light-absorbing layer.

Optionally, the connection layer may be similar to the connection layer 820 of the pixel apparatus 800 in FIG. 8 or the connection layer 920 of the pixel apparatus 900 in FIG. 9.

Optionally, the connection layer may include an encapsulation layer and a transition layer. A specific implementation of forming the encapsulation layer and the transition layer in the direction in which the light-emitting unit is away from the substrate is similar to steps S1520 and S1530.

S1630: Form the light-absorbing layer, the first filter unit, and a metal component in a direction in which the connection layer is away from the light-emitting unit. For step S1630, refer to the descriptions in steps S1540 and S1550.

Optionally, after step S1630 is performed, step S1560 or S1570 may be further performed.

In this embodiment of this application, the metal component may be disposed in the light-absorbing layer and/or the first filter unit, so that no additional multi-layer insulation layers (for example, the TOE-OC and the organic or inorganic ILD layer in FIG. 2 to FIG. 4) need to be disposed between the light-absorbing layer and the light-emitting unit for placing the metal component at the insulation layer. Therefore, in this embodiment of this application, peeling, cracking, or other problems caused by an inorganic ILD layer can be avoided, to improve reliability of the pixel apparatus. In addition, in this embodiment of this application, the light-absorbing layer and/or the first filter unit may be reused, to shorten an optical distance between the light-emitting unit and the first filter unit in the pixel apparatus, and further improve luminance of light emitted by the pixel apparatus and reduce luminance attenuation at a large angle of view. In addition, in this embodiment of this application, a thickness of the pixel apparatus can be reduced, and a quantity of optical masks can be reduced in a preparation process for the pixel apparatus, to reduce preparation costs.

An embodiment of this application further provides a pixel module. The pixel module includes a plurality of pixel apparatuses 500 in FIG. 5. Alternatively, the pixel module includes a plurality of pixel apparatuses 800 in FIG. 8. Alternatively, the pixel module includes a plurality of pixel apparatuses 900 in FIG. 9. This is not limited in this embodiment of this application.

For example, the pixel module includes a plurality of light-emitting units, an encapsulation layer, a transition layer, a plurality of first filter units, and a light-absorbing layer. Each of the plurality of light-emitting units is similar to the light-emitting unit 510 in FIG. 5. The encapsulation layer is similar to the encapsulation layer 520 in FIG. 5. The transition layer is similar to the transition layer 530 in FIG. 5. Each of the plurality of first filter units is similar to the first filter unit 540 in FIG. 5. The light-absorbing layer is similar to the light-absorbing layer 550 in FIG. 5.

For example, the pixel module includes a plurality of light-emitting units, a connection layer, a plurality of first filter units, a light-absorbing layer, and a plurality of metal components. Each of the plurality of light-emitting units is similar to the light-emitting unit 810 in FIG. 8. The connection layer is similar to the connection layer 820 in FIG. 8. Each of the plurality of first filter units is similar to the first filter unit 830 in FIG. 8. The light-absorbing layer is similar to the light-absorbing layer 840 in FIG. 8. Each of the plurality of metal components is similar to the metal component 850 in FIG. 8.

For example, the pixel module includes a plurality of light-emitting units, a connection layer, a plurality of first filter units, a light-absorbing layer, a plurality of metal components, and a plurality of second filter units. Each of the plurality of light-emitting units is similar to the light-emitting unit 910 in FIG. 9. The connection layer is similar to the connection layer 920 in FIG. 9. Each of the plurality of first filter units is similar to the first filter unit 930 in FIG. 9. The light-absorbing layer is similar to the light-absorbing layer 940 in FIG. 9. Each of the plurality of metal components is similar to the metal component 950 in FIG. 9. Each of the plurality of second filter units is similar to the second filter unit 960 in FIG. 9.

FIG. 17 is a block diagram of a structure of a display module according to an embodiment of this application. The display module 1700 in FIG. 17 includes the foregoing pixel module. To be specific, the display module 1700 includes a plurality of pixel apparatuses 1710, and each pixel apparatus 1710 may be any one of the pixel apparatus 500 in FIG. 5, the pixel apparatus 600 in FIG. 6, the pixel apparatus 700 in FIG. 7, the pixel apparatus 800 in FIG. 8, the pixel apparatus 900 in FIG. 9, the pixel apparatus 1000 in FIG. 10, the pixel apparatus 1100 in FIG. 11, the pixel apparatus 1200 in FIG. 12, or the pixel apparatus 1300 in FIG. 13. Each pixel apparatus 1710 may include a first filter unit in any one of a red (R) color, a green (G) color, or a blue (B) color. In other words, the pixel apparatus 1710 may include a CF in any one of the red (R) color, the green (G) color, or the blue (B) color.

It should be understood that an arrangement order of the plurality of pixel apparatuses 1710 in different colors in the display module 1700 is not limited in this embodiment of this application. The pixel apparatuses 1710 in different colors are pixel apparatuses including first filter units (namely, CFs) in different colors. For example, an arrangement order of the plurality of pixel apparatuses 1710 in different colors may be shown in FIG. 17, or may be another arrangement order.

An embodiment of this application further provides a display. The display includes the display module 1700 in FIG. 17.

An embodiment of this application further provides an electronic device. The electronic device includes the foregoing display.

A person of ordinary skill in the art may be aware that units and algorithm steps in examples described with reference to embodiments disclosed in this specification can be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

It can be clearly understood by a person skilled in the art that, for ease and brevity of description, for detailed working processes of the foregoing system, apparatus, and unit, reference may be made to corresponding processes in the foregoing method embodiments. Details are not described herein again.

In several embodiments provided in this application, it should be understood that the disclosed system, apparatus, and method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the shown or discussed mutual couplings or direct couplings or communication connections may be implemented through some interfaces. The indirect couplings or communication connections between the apparatuses or units may be implemented in electrical, mechanical, or other forms.

The units described as separate components may or may not be physically separate, and components shown as units may or may not be physical units, to be specific, may be located in one place, or may be distributed on a plurality of network units. Some or all of the units may be selected according to actual requirements to achieve objectives of solutions of embodiments.

In addition, functional units in embodiments of this application may be integrated into one processing unit, or each unit may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computing device (which may be a personal computer, a server, a network device, or the like) to perform all or some of the steps of the methods in embodiments of this application. The storage medium includes any medium that can store program code, for example, a USB flash drive, a removable hard disk, a read-only memory (read-only memory, ROM), a random access memory (random access memory, RAM), a magnetic disk, or a compact disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A pixel apparatus, comprising a light-emitting unit, an encapsulation layer, a transition layer, a light-absorbing layer, and a first filter unit, wherein
the light-emitting unit is configured to emit light;
the encapsulation layer is configured to protect the light-emitting unit;
the transition layer is disposed between the encapsulation layer and the first filter unit, and the transition layer is in contact with the encapsulation layer and the first filter unit; and
the light-absorbing layer is disposed in a direction in which the transition layer is away from the light-emitting unit, the light-absorbing layer is disposed around the first filter unit, and the light-absorbing layer is in contact with the transition layer and the first filter unit.

2. The pixel apparatus according to claim 1, wherein the transition layer does not comprise a metal component.

3. The pixel apparatus according to claim 1 or 2, wherein the pixel apparatus further comprises a metal component, and a part or all of the metal component is disposed in the light-absorbing layer and/or the first filter unit.

4. The pixel apparatus according to claim 3, wherein the metal component comprises a first metal layer and a second metal layer; and
a part or all of the first metal layer is disposed in the light-absorbing layer and/or the first filter unit; and/or
a part or all of the second metal layer is disposed in the light-absorbing layer and/or the first filter unit.

5. The pixel apparatus according to claim 4, wherein a height of a first surface of the first metal layer relative to the light-emitting unit is lower than a first height, the first height is a height of a first surface of the second metal layer relative to the light-emitting unit, the first surface of the first metal layer is a surface of the first metal layer that is close to the light-emitting unit, and the first surface of the second metal layer is a surface of the second metal layer that is close to the light-emitting unit.

6. The pixel apparatus according to any one of claims 3 to 5, wherein when a part or all of the metal component is disposed in a first part of the first filter unit, the pixel apparatus further comprises a second filter unit; and
the second filter unit is disposed in a direction in which the first part of the first filter unit is away from the light-emitting unit, the second filter unit is in contact with the first part of the first filter unit, a color of the second filter unit is different from a color of the first filter unit, and the first part of the first filter unit is an edge part of the first filter unit that is close to the light-absorbing layer.

7. The pixel apparatus according to any one of claims 1 to 6, wherein the pixel apparatus further comprises a lens, and the lens is disposed in a direction in which the first filter unit is away from the light-emitting unit.

8. A pixel apparatus, comprising a light-emitting unit, a connection layer, a light-absorbing layer, a first filter unit, and a metal component, wherein
the light-emitting unit is configured to emit light;
the connection layer is disposed between the light-emitting unit and the first filter unit, and the connection layer is in contact with the light-emitting unit and the first filter unit;
the light-absorbing layer is disposed in a direction in which the connection layer is away from the light-emitting unit, the light-absorbing layer is disposed around the first filter unit, and the light-absorbing layer is in contact with the first filter unit and the connection layer; and
a part or all of the metal component is disposed in the light-absorbing layer and/or the first filter unit.

9. The pixel apparatus according to claim 8, wherein the metal component comprises a first metal layer and a second metal layer; and
a part or all of the first metal layer is disposed in the light-absorbing layer and/or the first filter unit; and/or
a part or all of the second metal layer is disposed in the light-absorbing layer and/or the first filter unit.

10. The pixel apparatus according to claim 9, wherein a height of a first surface of the first metal layer relative to the light-emitting unit is lower than a first height, the first height is a height of a first surface of the second metal layer relative to the light-emitting unit, the first surface of the first metal layer is a surface of the first metal layer that is close to the light-emitting unit, and the first surface of the second metal layer is a surface of the second metal layer that is close to the light-emitting unit.

11. The pixel apparatus according to any one of claims 8 to 10, wherein when a part or all of the metal component is disposed in a first part of the first filter unit, the pixel apparatus further comprises a second filter unit; and
the second filter unit is disposed in a direction in which the first part of the first filter unit is away from the light-emitting unit, the second filter unit is in contact with the first part of the first filter unit, a color of the second filter unit is different from a color of the first filter unit, and the first part of the first filter unit is an edge part of the first filter unit that is close to the light-absorbing layer.

12. The pixel apparatus according to any one of claims 8 to 11, wherein the connection layer comprises an encapsulation layer and a transition layer;
the encapsulation layer is configured to protect the light-emitting unit; and
the transition layer is disposed between the encapsulation layer and the first filter unit, and the transition layer is in contact with the encapsulation layer, the first filter unit, and the light-absorbing layer.

13. The pixel apparatus according to claim 12, wherein the transition layer does not comprise a metal component.

14. The pixel apparatus according to any one of claims 8 to 13, wherein the pixel apparatus further comprises a lens, and the lens is disposed in a direction in which the first filter unit is away from the light-emitting unit.

15. A pixel apparatus preparation method, comprising:
forming a light-emitting unit of a pixel apparatus on a substrate, wherein the light-emitting unit is configured to emit light;
forming an encapsulation layer in a direction in which the light-emitting unit is away from the substrate, wherein the encapsulation layer is configured to protect the light-emitting unit;
forming a transition layer in a direction in which the encapsulation layer is away from the light-emitting unit; and
forming a light-absorbing layer and a first filter unit in a direction in which the transition layer is away from the encapsulation layer, wherein the transition layer is in contact with the encapsulation layer and the first filter unit, the light-absorbing layer is disposed around the first filter unit, and the light-absorbing layer is in contact with the transition layer and the first filter unit.

16. The method according to claim 15, wherein the transition layer does not comprise a metal component.

17. The method according to claim 15 or 16, wherein the method further comprises:
forming a metal component in the direction in which the transition layer is away from the encapsulation layer, wherein a part or all of the metal component is disposed in the light-absorbing layer and/or the first filter unit.

18. The method according to claim 17, wherein the forming a metal component in the direction in which the transition layer is away from the encapsulation layer comprises:
forming a first metal layer and a second metal layer in the direction in which the transition layer is away from the encapsulation layer, wherein a part or all of the first metal layer is disposed in the light-absorbing layer and/or the first filter unit, and/or a part or all of the second metal layer is disposed in the light-absorbing layer and/or the first filter unit.

19. The method according to claim 17 or 18, wherein the method further comprises:
forming a second filter unit in a direction in which a first part of the first filter unit is away from the light-emitting unit, wherein the second filter unit is in contact with the first part of the first filter unit, a color of the second filter unit is different from a color of the first filter unit, a part or all of the metal component is disposed in the first part of the first filter unit, and the first part of the first filter unit is an edge part of the first filter unit that is close to the light-absorbing layer.

20. The method according to any one of claims 15 to 19, wherein the method further comprises:
forming a lens in a direction in which the first filter unit is away from the light-emitting unit.

21. A pixel apparatus preparation method, comprising:
forming a light-emitting unit of a pixel apparatus on a substrate, wherein the light-emitting unit is configured to emit light;
forming a connection layer in a direction in which the light-emitting unit is away from the substrate; and
forming a light-absorbing layer, a first filter unit, and a metal component in a direction in which the connection layer is away from the light-emitting unit, wherein the connection layer is in contact with the light-emitting unit and the first filter unit, the light-absorbing layer is disposed around the first filter unit, the light-absorbing layer is in contact with the first filter unit and the connection layer, and a part or all of the metal component is disposed in the light-absorbing layer and/or the first filter unit.

22. The method according to claim 21, wherein the forming a metal component in a direction in which the connection layer is away from the light-emitting unit comprises:
forming a first metal layer and a second metal layer in the direction in which the connection layer is away from the light-emitting unit, wherein a part or all of the first metal layer is disposed in the light-absorbing layer and/or the first filter unit, and/or a part or all of the second metal layer is disposed in the light-absorbing layer and/or the first filter unit.

23. The method according to claim 21 or 22, wherein the method further comprises:
forming a second filter unit in a direction in which a first part of the first filter unit is away from the light-emitting unit, wherein the second filter unit is in contact with the first part of the first filter unit, a color of the second filter unit is different from a color of the first filter unit, a part or all of the metal component is disposed in the first part of the first filter unit, and the first part of the first filter unit is an edge part of the first filter unit that is close to the light-absorbing layer.

24. The method according to any one of claims 21 to 23, wherein the forming a connection layer in a direction in which the light-emitting unit is away from the substrate comprises:
forming an encapsulation layer in the direction in which the light-emitting unit is away from the substrate, wherein the encapsulation layer is configured to protect the light-emitting unit; and
forming a transition layer in a direction in which the encapsulation layer is away from the substrate, wherein the transition layer is disposed between the encapsulation layer and the first filter unit, and the transition layer is in contact with the encapsulation layer, the first filter unit, and the light-absorbing layer.

25. The method according to claim 24, wherein the transition layer does not comprise a metal component.

26. The method according to any one of claims 21 to 25, wherein the method further comprises:
forming a lens in a direction in which the first filter unit is away from the light-emitting unit.

27. A pixel module, comprising a plurality of pixel apparatuses according to any one of claims 1 to 7 or any one of claims 8 to 14.

28. A display module, comprising a plurality of pixel modules according to claim 27.

29. A display, comprising the display module according to claim 28.

30. An electronic device, comprising the display according to claim 29.
